(19) **Europäisches Patentamt / European Patent Office / Office européen des brevets**

(11) **EP 3 238 231 B1**

(12) **FASCICULE DE BREVET EUROPEEN**

(45) Date de publication et mention
de la délivrance du brevet:
**23.08.2023 Bulletin 2023/34**

(21) Numéro de dépôt: **15817367.4**

(22) Date de dépôt: **22.12.2015**

(51) Classification Internationale des Brevets (IPC):
**H01L 21/306** *(2006.01)* **H01L 21/3065** *(2006.01)*
**H01L 21/308** *(2006.01)* **H01L 21/311** *(2006.01)*
**H01L 31/0236** *(2006.01)* **H01L 33/00** *(2010.01)*
**G03F 7/00** *(2006.01)* **B81C 1/00** *(2006.01)*

(52) Classification Coopérative des Brevets (CPC):
**B81C 1/00103; B81C 1/00587; G03F 7/0002;
H01L 21/30608; H01L 21/3065; H01L 21/3086;
H01L 21/31111; H01L 21/31144; H01L 31/02363;
H01L 33/20;** B81C 2201/0136; B81C 2201/0153;
H01L 33/007; H01L 33/22

(86) Numéro de dépôt international:
**PCT/EP2015/081057**

(87) Numéro de publication internationale:
**WO 2016/102605 (30.06.2016 Gazette 2016/26)**

(54) **PROCÉDÉ D'OBTENTION DE MOTIFS DANS UNE COUCHE**

VERFAHREN ZUR ERZEUGUNG VON MUSTERN IN EINER SCHICHT

METHOD FOR OBTAINING PATTERNS IN A LAYER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.12.2014 FR 1463145**

(43) Date de publication de la demande:
**01.11.2017 Bulletin 2017/44**

(73) Titulaire: **Commissariat à l'Énergie Atomique
et aux Énergies Alternatives
75015 Paris (FR)**

(72) Inventeurs:
• **LANDIS, Stéphan
38210 Tullins (FR)**
• **POSSEME, Nicolas
38360 Sassenage (FR)**
• **BARNOLA, Sébastien
38190 Villard-Bonnot (FR)**
• **DAVID, Thibaut
38570 Goncelin (FR)**
• **NOURI, Lamia
38100 Grenoble (FR)**

(74) Mandataire: **Hautier, Nicolas
Cabinet Hautier
20, rue de la Liberté
06000 Nice (FR)**

(56) Documents cités:
**EP-A2- 2 264 772     FR-A1- 2 977 071
FR-A1- 2 995 134     US-A1- 2011 097 827
US-A1- 2013 284 697     US-A1- 2014 175 051**

• ZHANNA SMAGINA ET AL: "Nucleation and epitaxial growth of Ge nanoislands on Si surface prepatterned by ion irradiation", PHYSICA STATUS SOLIDI. A: APPLICATIONS AND MATERIALS SCIENCE, vol. 210, no. 8, 5 juillet 2013 (2013-07-05), pages 1522-1524, XP055219937, DE ISSN: 1862-6300, DOI: 10.1002/pssa.201200906
• WEI ZHOU ET AL: "Fabrication of bridged-grain polycrystalline silicon thin film transistors by nanoimprint lithography", THIN SOLID FILMS, vol. 534, 1 mai 2013 (2013-05-01), pages 636-639, XP055219967, CH ISSN: 0040-6090, DOI: 10.1016/j.tsf.2013.02.114

**(Cont. page suivante)**

• SCHMIDT CHRISTOPH ET AL: "Artificial sub-[mu]m magnetic patterning by He+ion bombardment through a mask fabricated by Ultraviolet NanoImprint Lithography (UV-", NUCLEAR INSTRUMENTS & METHODS IN PHYSICS RESEARCH. SECTION B: BEAM INTERACTIONS WITH MATERIALS AND ATOMS, vol. 322, 29 janvier 2014 (2014-01-29), pages 59-62, XP028608291, ISSN: 0168-583X, DOI: 10.1016/J.NIMB.2014.01.005

## Description

DOMAINE TECHNIQUE DE L'INVENTION

L'invention concerne en général la réalisation de structures bidimensionnelles (2D) ou tridimensionnelles (3D) c'est-à-dire la formation de structures ayant un profil présentant au moins deux niveaux discrets de hauteurs ou qui présentent un profil analogique avec une variation continue des tangentes de la forme du profil.

Elle trouve pour application particulièrement avantageuse le domaine de la lithographie par impression nanométrique où l'on procède tout d'abord à la reproduction des reliefs dans un matériau temporaire afin que ces derniers puissent être ensuite transférer fidèlement, par l'intermédiaire du matériau temporaire, dans un substrat ou une couche mince.

ÉTAT DE LA TECHNIQUE

Les techniques de transfert de reliefs par impression encore appelées nano-impression de l'anglais « nanoimprint », appartiennent à une technologie générique qui regroupe une multitude d'approches très différentes mais qui possèdent toutes néanmoins un point commun : l'utilisation d'un tampon ou moule (de l'anglais « stamp » ou « mold ») permettant de transférer sur une surface ou dans l'épaisseur d'un matériau un motif 2D ou 3D. Toutes ces approches d'une même technologie ont donc en commun qu'un contact intime entre le support originel de l'information (le moule) et celui recevant cette information (le substrat) soit réalisé au cours de cette opération.

Dans tous les cas, les technologies de nano-impression se différencient des procédés de lithographie conventionnels (photolithographie classique à l'aide de masques, lithographie électronique, lithographie par rayons X ou encore par ultra-violet ou UV) par le mécanisme fondamental qui va créer les motifs. Pour toutes les techniques classiques ci-dessus, les motifs sont créés par le biais d'un contraste physico-chimique. La résine exposée à la lumière ou aux rayonnements, si elle est de tonalité positive, pourra être sélectivement développée. C'est l'inverse qui se produit si la résine est de tonalité négative. Pour la nano-impression le contraste est topographique : c'est le déplacement de matière et l'écoulement de la résine dans les cavités du moule qui vont permettre la création de motifs spécifiques.

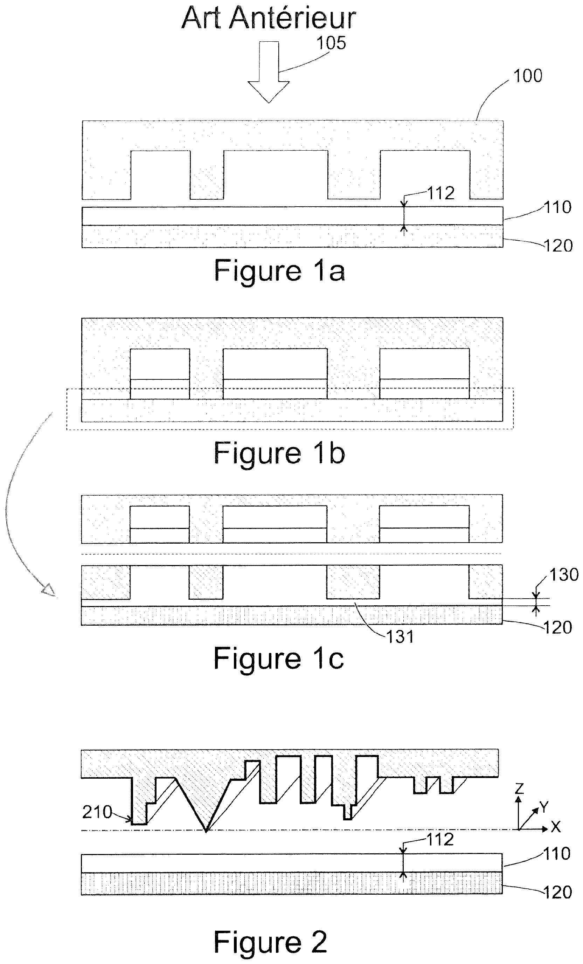

Les **figures 1a à 1c** illustrent une opération d'impression au cours de laquelle un moule 100 pénètre dans une couche de résine 110 surmontant un substrat 120 afin de former dans la résine 110 des motifs qui pourront ensuite être transférés dans le substrat 120 par gravure.

La figure 1b illustre un cas idéal dans lequel les reliefs du moule 100 viennent en contact avec le substrat 120 en supprimant toute présence de résine 110 entre le sommet des reliefs du moule 110 et le substrat 120.

En pratique, les conditions de mise en oeuvre sont telles que dans la majorité des cas on applique sur le moule 100 une pression 105 inférieure à 100 bars, pendant un temps inférieur à une heure et à une température qui ne dépasse pas 100°C. Dans ces conditions on constate alors qu'avec les matériaux utilisés comme résine qui sont typiquement des monomères, oligomères ou polymères, les propriétés de ceux-ci sont telles qu'elles ne permettent pas aux reliefs du moule 100 d'atteindre l'interface formée par le substrat 120 et la résine 110 pendant le pressage.

Par conséquent, comme illustré sur la figure 1c, une couche résiduelle 131 de résine reste présente entre la surface du substrat 120 et les reliefs du moule 100. L'épaisseur 130 de cette couche résiduelle 131 dépend des conditions de pressage mais aussi de la géométrie du moule 100 et du volume initial de résine 110 disponible.

Le problème s'est donc rapidement posé de savoir si une approche prédictive du procédé de pressage pouvait être proposée et en particulier si il était possible de prévoir l'épaisseur résiduelle 130 connaissant la géométrie du moule 100 ainsi que l'épaisseur initiale 112 de polymère imprimé. Ceci est illustré par la **figure 2** où l'on définit la surface d'un moule à l'aide d'une fonction *p(x, y)* décrivant son profil 210.

En considérant que le matériau à imprimer puisse s'écouler sur des distances identiques à celle de l'échantillon, il est alors possible d'établir un critère simple pour savoir si le moule peut-être complètement rempli ou non. La figure 2 représente un profil arbitraire d'une structure 3D à imprimer avec l'épaisseur initiale 112 de matériau à mettre en forme, qui est noté *hi* ci-après, *S* étant la surface du substrat et du moule et *p(x,y)* la fonction mathématique décrivant le profil 210 du moule. Le calcul du ratio *(f)* entre le volume à remplir dans le moule *(Vm)* et le volume de matière incompressible disponible *(Vi)* permet d'identifier trois configurations.

$$ f = \frac{Vm}{Vi} = \frac{\iint_S p(x,y)dxdy}{h_i S} \begin{cases} < 1 \\ = 1 \\ > 1 \end{cases} $$

Pour un ratio *f* inférieur à 1, le remplissage total du moule est possible puisque la matière est présente en excès. Dans ce cas de figure l'épaisseur résiduelle théorique *(hr)* pourrait être calculée et serait alors donnée par la relation suivante :

$$ h_r = h_i - \frac{\iint_S p(x,y)dxdy}{S} $$

Un ratio égal à 1 implique que le volume de matière disponible est équivalent au volume à remplir, impliquant donc une épaisseur résiduelle théorique égale à zéro. Enfin, pour un ratio inférieur à 1, les cavités du moule ne pourront être complètement remplies.

On notera que cette relation ne fait apparaître ni les conditions de pressage (température, pression, temps d'impression) ni les propriétés du matériau (viscosité, énergie de surface) et que par conséquent elle ne peut être considérée pour décrire la dynamique du processus. Elle ne peut que refléter un état final idéal du procédé. Il faut également souligner que cette approche est très simplifiée et n'est que très peu applicable telle quelle de par la complexité de l'interaction fluide (résine) avec la structure (moule) pendant l'étape de pressage. Elle peut être vérifiée néanmoins pour l'impression de motifs de densité constante présents sur des surfaces supérieures à plusieurs millimètres carrés ($mm^2$). Dès qu'une modification de la densité des motifs à imprimer intervient, et ce même à courte distance, cette approche n'est plus valide et des déformations de moule pendant le pressage doivent être considérées. Cela rend l'approche prédictive quasiment impossible, voire très difficile, même avec des outils numériques avancés.

La présence de la couche résiduelle 131 de résine est donc un problème spécifique à la technique de nano-impression. La présence d'une couche résiduelle et son épaisseur engendrent deux problématiques totalement nouvelles pour la mise en oeuvre de la nano-impression :

- le problème se pose, après pressage, d'avoir à supprimer cette couche résiduelle 131 de résine tout en conservant la forme et les dimensions des motifs imprimés afin d'obtenir un masque de résine présentant les mêmes caractéristiques que celles qui seraient obtenues avec les techniques standard de lithographie ;
- un autre problème est d'assurer l'uniformité de son épaisseur afin que les étapes technologiques qui suivent puissent être appliquées sans difficulté.

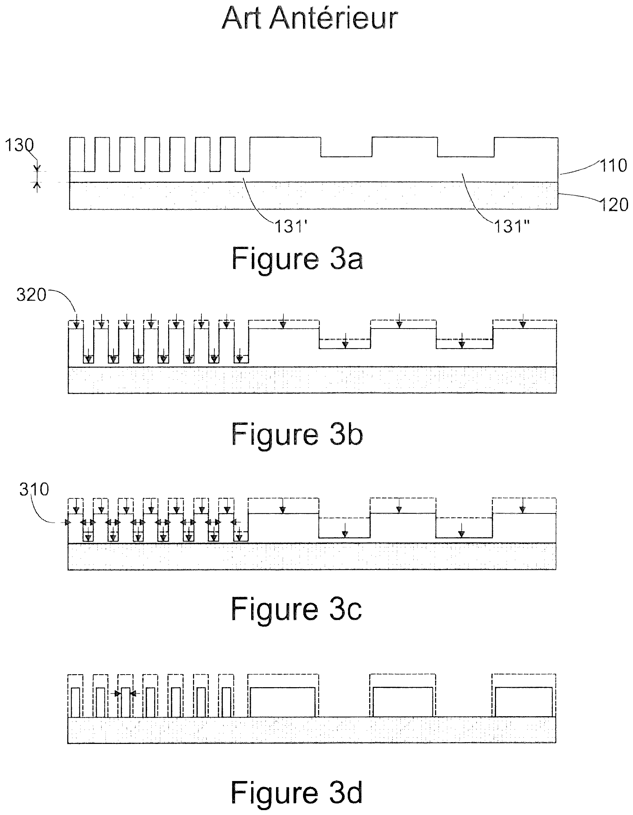

Le premier point ne constitue pas une barrière technologique lorsque le matériau mis en forme sera par la suite un élément fonctionnel du composant en cours de fabrication. Néanmoins, dans une grande majorité de situations, la résine imprimée ne sert que de masque pour transférer ensuite l'information topographique dans un matériau sous-jacent à l'aide d'un procédé de gravure. Dans ces cas-là il est alors nécessaire de disposer d'un procédé de gravure le plus anisotrope possible (selon la direction Z du repère illustré en figure 2), c'est à dire ayant une vitesse de gravure parallèle au plan du substrat (plan X,Y) la plus faible possible voire, idéalement, qui serait nulle. Dans le cas contraire, toute étape de gravure de l'épaisseur résiduelle engendre des modifications de dimensions horizontales des motifs imprimés et par conséquent une perte d'information généralement inacceptable lors de l'étape de lithographie correspondante comme illustré sur les **figures 3a à 3d** décrites ci-dessous. La mise au point de procédés de gravure les plus anisotropes possibles entre deux matériaux est une contrainte très courante dans le domaine des micro et nanotechnologies. Leur mise en oeuvre peut être très compliquée pour des dimensions très petites, inférieures à 30 nanomètres (nm), et pour des profils 3D.

Les figures 3a à 3d illustrent les problèmes exposés ci-dessus qui résultent de la nécessité d'avoir à enlever après impression la couche résiduelle 131 de résine 110 à l'aide d'un procédé qui doit pouvoir aussi tenir compte de la non uniformité potentielle de cette couche. Ce n'est qu'après enlèvement de la couche résiduelle 131 que l'on pourra ensuite procéder à la gravure du substrat sous-jacent 120. Les figures 3a à 3d mettent en évidence l'impact des vitesses de gravure horizontale 310 et verticale 320 sur la conservation des dimensions originales.

On remarquera ici que l'uniformité de l'épaisseur résiduelle 130 est alors un élément important pour faciliter son retrait et permettre l'utilisation du masque de résine comme masque de gravure. Comme mentionné précédemment, cette valeur va dépendre en général de la géométrie du moule incluant des paramètres géométriques tels que les tailles des différents motifs, leurs densités, les ruptures de symétrie de la trame des motifs. La valeur de l'épaisseur résiduelle va aussi dépendre, comme on l'a vu sur les figures 1 et 2, de l'épaisseur initiale 112 à imprimer ainsi que des conditions d'impression : température, force appliquée, temps d'impression. Sur les figures 3a, on a illustré avec les références 131' des zones où l'épaisseur résiduelle est plus faible que sous d'autres motifs 131".

Un objet de la présente invention est donc de proposer un nouveau procédé qui prenne en compte, au moins en partie, les difficultés décrites ci-dessus résultant de la présence d'une couche résiduelle de résine à l'issue des opérations d'impression à partir d'un moule en vue de transférer par gravure les reliefs de celui-ci dans un substrat ou une couche mince d'un dispositif en cours de fabrication.

Les autres objets, caractéristiques et avantages de la présente invention apparaîtront à l'examen de la description suivante et des dessins d'accompagnement. Il est entendu que d'autres avantages peuvent être incorporés.

Le document "Nucleation and epitaxial growth of Ge nanoislands on Si surface prepatterned by ion irradiation", PHYSICA STATUS SOLIDI. A: APPLICATIONS AND MATERIALS SCIENCE, vol. 210, no. 8, 5 July 2013 (2013-07-05), décrit un procédé de réalisation d'îlots de germanium sur un substrat structuré de silicium. Le substrat de silicium est structuré en mettant en oeuvre un procédé qui comprend une étape de réalisation d'un masque par nanoimpression puis une implantation d'ions Ge+ à travers ce masque. Cette implantation forme ainsi des zones implantées par les ions Ge+. Le procédé prévoit ensuite des cycles comprenant chacun une oxydation sélective du silicium implanté et un retrait de la portion oxydée par rapport aux portions non oxydées. Le procédé prévoit ensuite une étape de croissance par épitaxie du germanium dans les portions gravées du silicium. Ce procédé s'avère particulièrement complexe à mettre en oeuvre et non adapté à une réalisation précise de motifs en creux ou en saillie possiblement complexes.

Le document US20130284697 décrit un procédé de réalisation de motifs en trois dimensions dans une couche sous-jacente. Ce procédé comprend une étape de réalisation de motifs antérieurs par impression nanométrique dans une couche imprimable surmontant la couche sous-jacente. Le procédé comprend ensuite une étape de modification de la couche sous-jacente par implantation d'ions à travers la couche imprimable de sorte à former dans la couche sous-jacente des zones modifiées par implantation. Le procédé comprend également une étape de gravure sélective des zones modifiées par rapport aux zones non implantées, de sorte à obtenir des motifs en trois dimensions. Il s'avère en pratique qu'il est difficile d'obtenir des motifs précis en mettant en oeuvre ce procédé.

RÉSUMÉ DE L'INVENTION

Pour atteindre cet objectif, un aspect de la présente invention concerne un procédé de réalisation de motifs ultérieurs selon la revendication 1.

Ainsi, l'invention permet d'obtenir dans la couche sous-jacente des motifs possiblement complexes et très précis en supprimant les inconvénients habituellement induits par la couche résiduelle.

Comme indiqué ci-dessus, la gravure de cette couche résiduelle qui est inévitablement obtenue en fin d'impression, entraine, avec les procédés connus, des modifications non souhaitées et difficilement prévisibles au niveau de la forme et/ou des dimensions des motifs finaux.

L'invention, en se basant sur une étape de modification de la couche sous-jacente à travers la couche imprimable, permet de transférer dans cette couche sous-jacente les motifs imprimés ou des motifs fonction des motifs imprimés, sans avoir à retirer la couche résiduelle. Les motifs obtenus ne sont donc pas déformés par une étape de retrait de la couche résiduelle.

Ainsi, la couche imprimable est une carbonée. Elle contient ainsi des atomes de carbone. Typiquement il s'agit d'une résine déformable à froid ou à chaud.

Ainsi, l'épaisseur résiduelle dans le fond des motifs est suffisante pour former une barrière empêchant, lors de ladite implantation, à du carbone provenant de la couche imprimable carbonée de pénétrer à l'intérieur de la couche sous-jacente.

Dans le cadre du développement de la présente invention il a été observé que ce mode de réalisation évite que des atomes de carbone présents dans la couche imprimable soient arrachés à la surface de cette dernière lors de l'implantation et pénètrent dans la couche sous-jacente à graver. Cela aurait pour effet de modifier la surface de la couche sous-jacente en créant un film surfacique enrichi en carbone au droit des motifs. Un tel film empêcherait la gravure cette dernière lors de l'étape de gravure des zones modifiées. La couche sous-jacente serait donc non gravée ou bien les motifs ne seraient pas transférés avec précision. Pour cela le procédé selon l'invention prévoit que la couche imprimable forme, dans le fond des motifs imprimés, une épaisseur résiduelle suffisante pour former une barrière qui piège les atomes de carbone arrachés à la couche imprimable carbonée lors de l'implantation.

Cela permet d'améliorer considérablement le contrôle dimensionnel des motifs réalisés dans la couche sous-jacente à graver.

Selon un mode de réalisation, après l'étape de modification, au moins une étape de retrait des zones modifiées est effectuée de manière sélective par rapport aux zones non modifiées, de manière à laisser en place uniquement les zones non modifiées de la couche sous-jacente.

Dans le cadre de la présente invention, l'adjectif « sous-jacente» dans l'expression « couche sous-jacente» est relatif à la direction et le sens de l'implantation des ions uniquement. La couche sous-jacente est positionnée en aval de la couche imprimable par rapport au sens d'implantation des ions. Sur les figures qui suivent, la direction et le sens d'implantation des ions étant verticale et vers le bas, la couche sous-jacente est positionnée plus bas que la couche imprimable. Si l'implantation est dirigée verticalement et vers le haut, la couche sous-jacente, toujours positionnée en aval de la couche imprimable par rapport au sens d'implantation des ions, serait alors positionnée sur les figures plus haut que la couche imprimable.

De manière facultative, l'invention peut en outre présenter au moins l'une quelconque des caractéristiques suivantes :

- L'épaisseur résiduelle dans le fond des motifs est supérieure ou égale à 20 nanomètres ($10^{-9}$ mètres), et avantageusement supérieure ou égale à 30 nanomètres. Cette épaisseur permet de s'assurer que les atomes de carbones provenant de la couche imprimable carbonée soient stoppés par l'épaisseur résiduelle lors de l'implantation et ne pénètrent pas dans la couche sous-jacente à graver.

- Selon un mode de réalisation, les matériaux de la couche imprimable et de la couche sous-jacente ainsi que les paramètres de l'implantation, notamment la nature des ions, sont choisis de manières à ce que les matériaux de la couche imprimable et de la couche sous-jacente présentent des capacités de pénétration des ions identiques.

Ainsi, à conditions d'implantation égales, notamment pour une même énergie des ions, les ions pénètrent de la même manière dans une couche faite du matériau de la couche imprimable et dans une couche faite du matériau de la couche sous-jacente.

Ainsi, lorsque ces couches sont empilées, l'implantation à partir de la couche imprimable permet de reproduire les motifs de cette dernière dans la couche sous-jacente. On peut qualifier l'implantation « de conforme », le profil défini par la frontière entre les zones implantées et les zones non implantées reproduisant le profil défini par les motifs imprimés dans la couche imprimable.

Cette implantation d'ions permet ainsi d'effectuer un transfert de motifs depuis la couche imprimable vers la couche sous-jacente, les motifs transférés étant formés par le matériau modifié de la couche sous-jacente.

- Selon un mode de réalisation alternatif, les matériaux de la couche imprimable et de la couche sous-jacente ainsi que les paramètres de l'implantation sont choisis de manières à ce que les matériaux de la couche imprimable et de la couche sous-jacente présentent des capacités différentes de pénétration des ions. Ainsi l'implantation à partir de la couche imprimable permet de générer dans la couche sous-jacente des motifs non identiques à ceux de la couche imprimable. Typiquement les motifs de la couche sous-jacente sont des homothéties de ceux de la couche imprimable.

- Selon un mode de réalisation, l'étape de réalisation de motifs antérieurs est réalisée de manière à ce que l'épaisseur minimale de la couche imprimable soit supérieure à la profondeur minimale d'implantation des ions, la profondeur minimale étant prise selon la direction d'implantation et à partir de la surface de la couche imprimable. Ainsi, la profondeur de pénétration des ions est inférieure ou égale à l'épaisseur minimale de la couche imprimable. Typiquement cette épaisseur minimale correspond à une épaisseur résiduelle laissée en place par l'étape de nano-impression.

L'épaisseur minimale de la couche imprimable correspond à la couche résiduelle. En réglant l'épaisseur de la couche résiduelle, on s'assure ainsi que les ions peuvent être implantés en continue depuis la surface de la couche sous-jacente.

Alternativement, avant l'étape d'implantation, on dispose entre la couche imprimable et la couche sous-jacente une couche tampon, l'étape de réalisation de motifs antérieurs étant réalisée de manière à ce que l'épaisseur minimale de la couche imprimable additionnée de l'épaisseur de la couche tampon soit supérieure à la profondeur minimale d'implantation des ions, la profondeur minimale étant prise selon la direction d'implantation et à partir de la surface de la couche imprimable.

De manière générale, les conditions d'implantation, l'épaisseur de la couche résiduelle et l'épaisseur de l'éventuelle couche tampon sont réglées de manière à ce qu'au niveau des zones modifiées les ions soient implantés en continu depuis la surface de la couche à graver.

Alternativement, on peut prévoir que la profondeur minimale d'implantation est supérieure à l'épaisseur de la couche résiduelle plus l'épaisseur de l'éventuelle couche tampon. Ainsi, au niveau des zones modifiées les ions ne sont pas implantés en continu depuis la surface de la couche à graver.

Un autre objet de la présente invention concerne un dispositif microélectronique comprenant une pluralité de motifs réalisés selon l'un ou l'autre des procédés de l'invention. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La FIGURE 1, composée des figures 1a à 1c, décrit les étapes d'une opération de nano-impression selon l'art antérieur.
La FIGURE 2 montre la définition d'un moule à l'aide d'une fonction décrivant son profil.
La FIGURE 3, composée des figures 3a à 3d, illustre les problèmes posés par l'enlèvement de la couche résiduelle de résine après une opération d'impression.

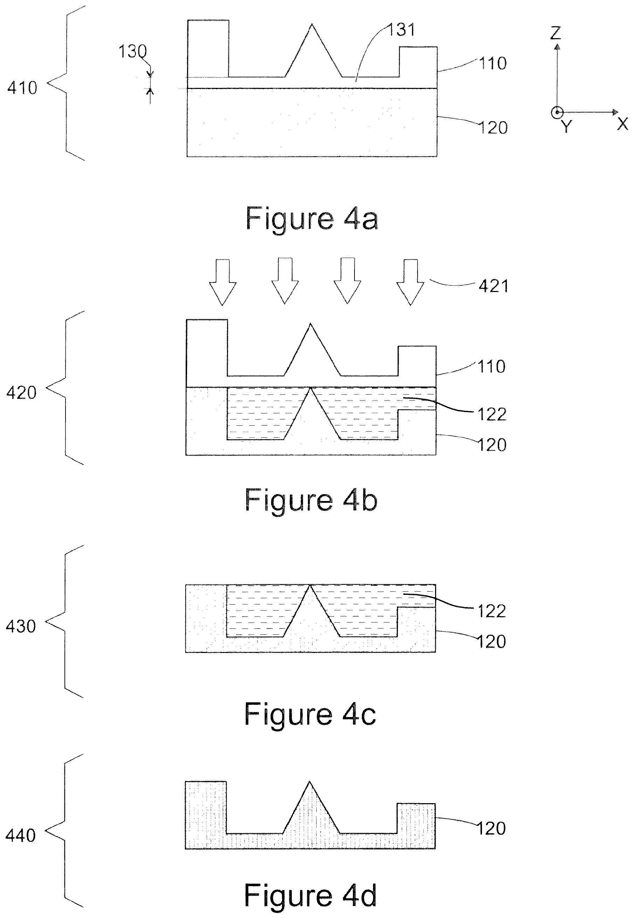

La FIGURE 4, composée des figures 4a à 4d, décrit brièvement les étapes principales d'un procédé selon un mode de réalisation de l'invention.

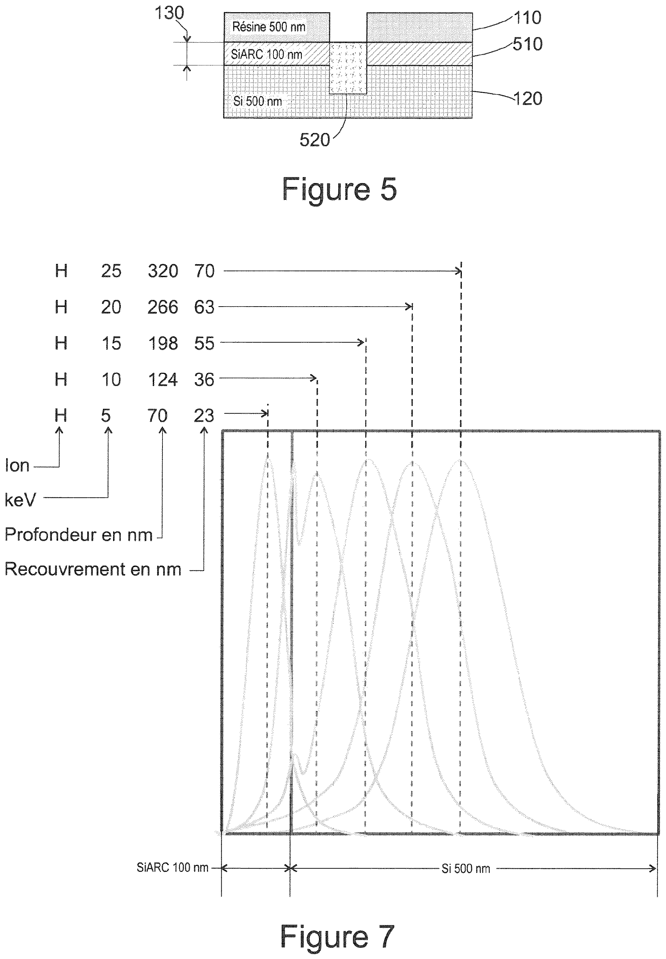

La FIGURE 5 illustre un empilement de couche comprenant successivement un substrat, une couche tampon et une couche imprimable.

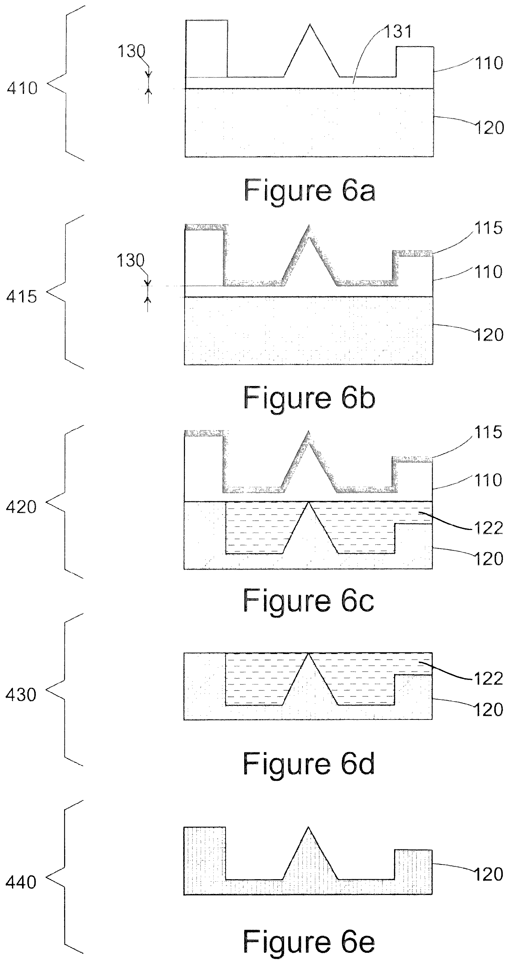

La FIGURE 6, composée des figures 6a à 6e illustre une variante du procédé de l'invention dans laquelle on utilise une couche de protection de la résine.
La FIGURE 7 illustre des opérations d'implantation du substrat de la figure 5 au travers de la couche tampon.

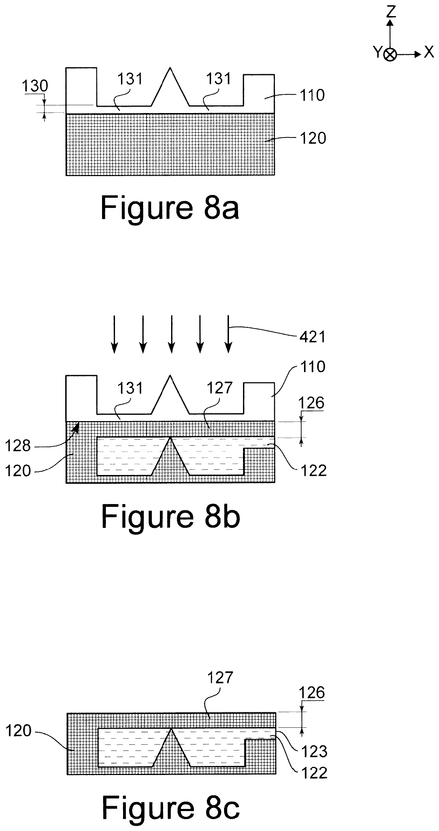

La FIGURE 8, composée des figures 8a à 8c, illustre un procédé selon un autre mode de réalisation de l'invention dans laquelle on réalise des structures enterrées dans un substrat.

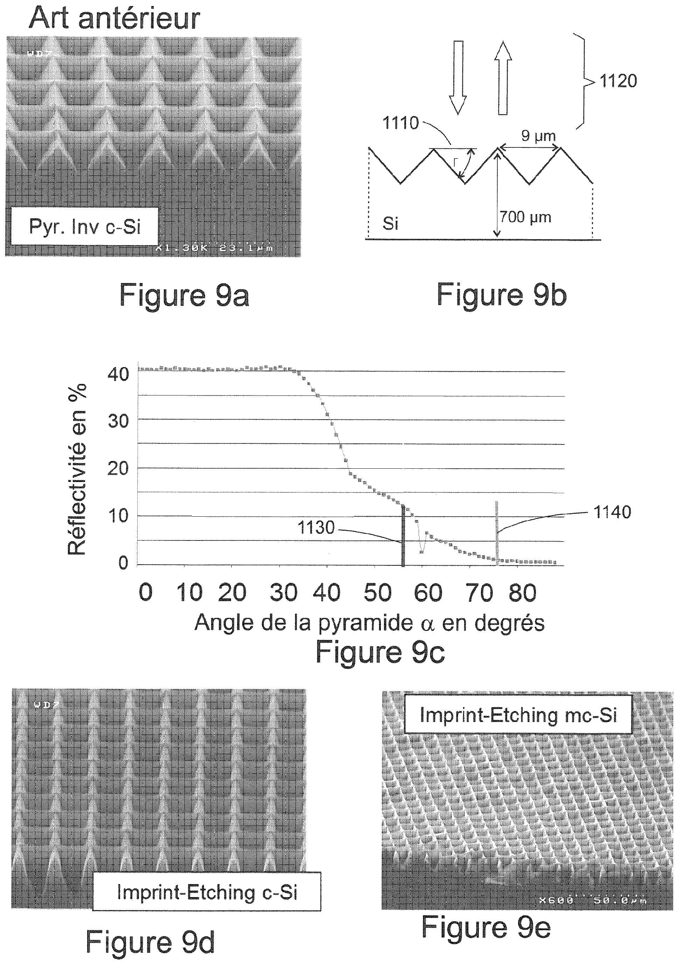

La FIGURE 9, composée des figures 9a à 9e, illustre une mise en oeuvre des procédés de l'invention qui permet d'obtenir une structure pyramidale à fortes pentes.

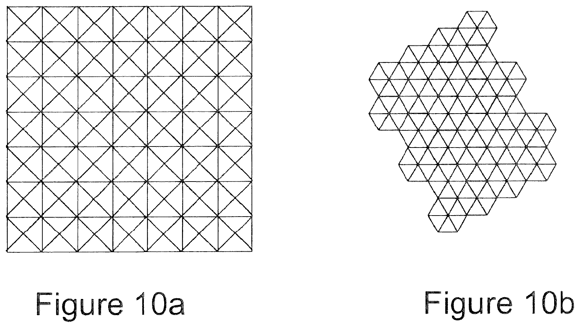

La FIGURE 10, composée des figures 10a et 10b, compare des structures pyramidales et hexagonales.

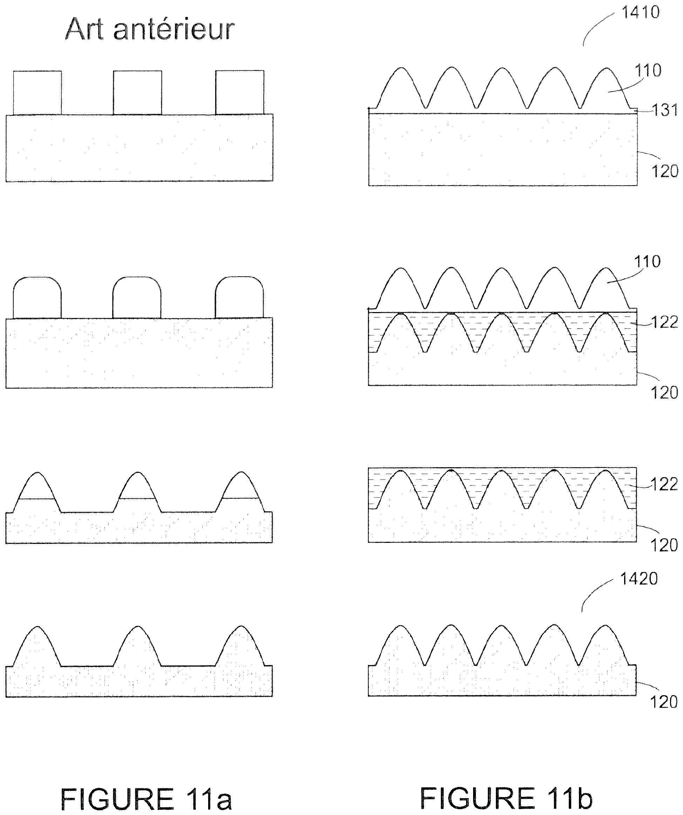

La FIGURE 11, composée des figures 11a et 11b, compare des structurations de surface d'un substrat en saphir obtenues, d'une part, avec un procédé de l'art antérieur, et d'autre part, en utilisant un procédé selon un exemple de réalisation de l'invention.

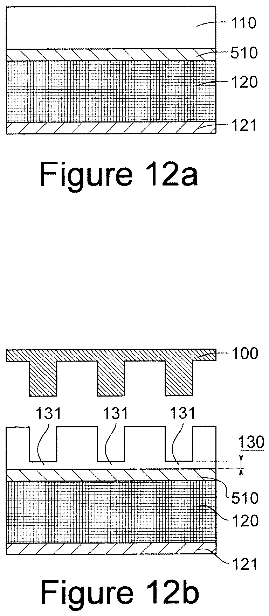

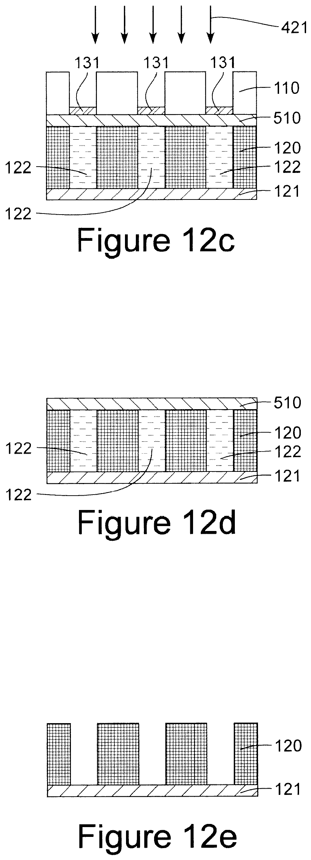

La FIGURE 12, composée des figures 12a à 12e, décrit brièvement les étapes principales d'un procédé selon un mode de réalisation de l'invention particulièrement bien adapté à la gravure de SiOCH.

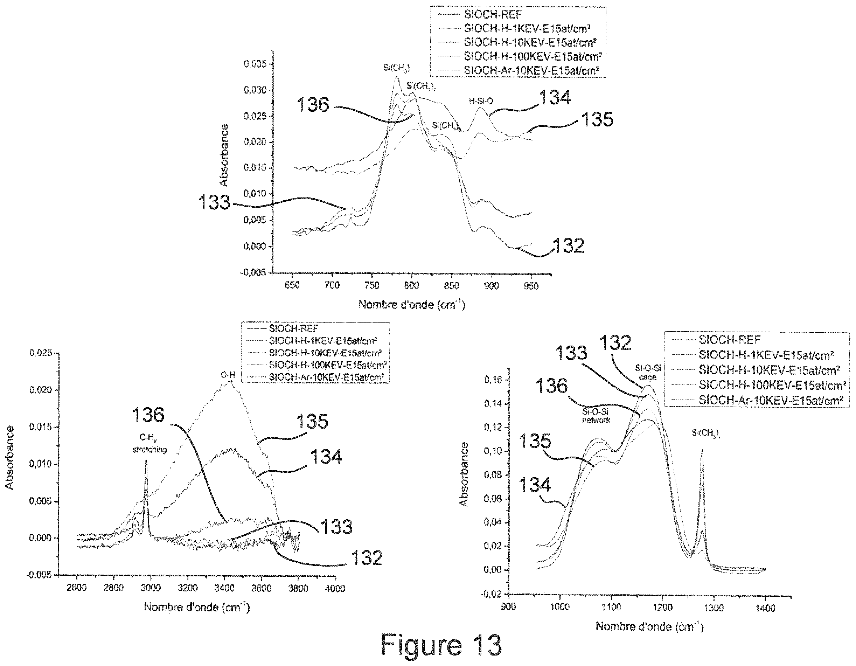

La FIGURE 13 illustre la structure du SiOCH après l'implantation d'hélium (H) et d'argon (Ar) dans le procédé illustré en figure 12.

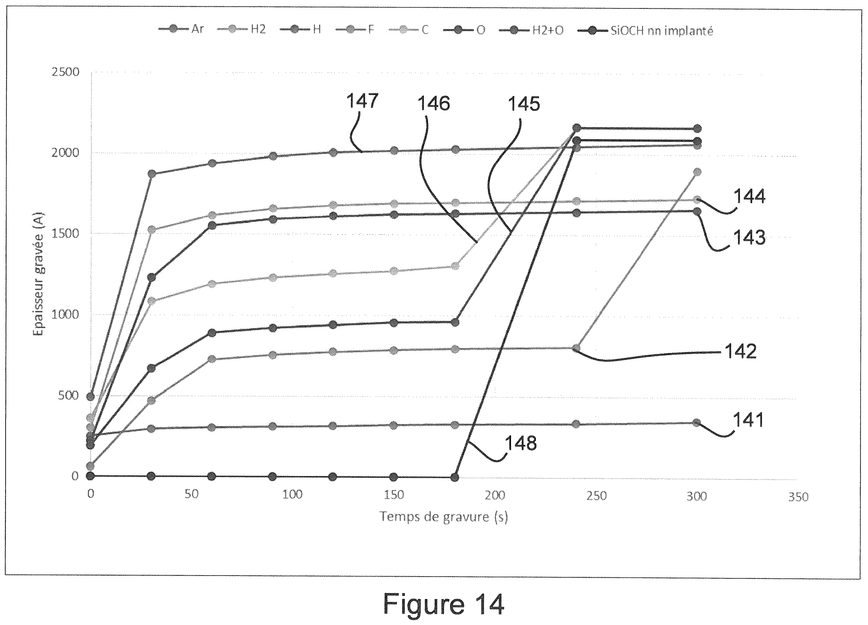

La FIGURE 14 compare l'épaisseur de SiOCH gravée en fonction du temps de gravure, par une solution HF diluée à 1%, pour différentes espèces implantées dans le SiOCH et pour du SiOCH non implanté.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches, films reliefs et motifs ne sont pas représentatives de la réalité.

## DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :

- Selon un mode de réalisation, les paramètres de l'implantation comprennent notamment une direction d'implantation. La direction d'implantation (direction Z du repère illustré en figure 4a) est perpendiculaire au plan principal dans lequel s'étend la couche sous-jacente. Il s'agit typiquement du plan X,Y du repère illustré en figure 4a.

- Selon un mode de réalisation, les paramètres de l'implantation sont choisis de manière à ce que les motifs ultérieurs présentent une géométrie identique à celle des motifs antérieurs.

- Selon un mode de réalisation, les matériaux des couches imprimables et de la couche sous-jacente, ainsi que la nature des ions sont choisis de manière à ce que la pénétration des ions dans l'un des matériaux pris parmi le matériau de la couche imprimable et le matériau de la couche sous-jacente soit supérieure à la pénétration des ions dans l'autre des matériaux pris parmi le matériau de la couche imprimable et le matériau de la couche sous-jacente.

- Selon un mode de réalisation, l'étape de retrait comprend une étape de gravure des zones modifiées sélectivement aux zones non modifiées, l'étape de gravure étant une gravure par voie humide. Ce procédé est rapide et parfaitement conforme aux contraintes industrielles en termes de productivité. En particulier la gravure humide offre un gain de temps tout en apportant un bon contrôle dimensionnel et un bon état de surface. Alternativement l'étape de gravure est effectuée par voie sèche.

- De préférence, l'implantation d'ions est réalisée de manière à ce que la couche sous-jacente présente une zone non modifiée continue située entre les zones modifiées et une face de la couche sous-jacente par laquelle les ions pénètrent lors de l'implantation. Ainsi, la couche sous-jacente présente une épaisseur non modifiée séparant les zones modifiées de l'extérieur de la couche sous-jacente. Cette épaisseur permet ainsi d'encapsuler et de protéger les zones modifiées avant leur retrait sélectivement aux zones non modifiées. Les motifs gravés dans la couche sous-jacente forment ainsi des structures enterrées. Elles peuvent présenter des propriétés électriques, optiques, magnétiques, thermiques particulières et notamment différentes de celle des zones non modifiées.

- De préférence, l'implantation est réalisée au moyen d'un implanteur configuré de manière à implanter des ions qu'à partir d'une profondeur non nulle de la couche sous-jacente. Ainsi l'implanteur n'implante pas les ions de manière continue depuis la surface de la couche sous-jacente à travers laquelle les ions sont implantés.

- De préférence, l'implantation est réalisée pleine plaque c'est-à-dire sur toute la surface de l'empilement.

- Selon un mode de réalisation, le procédé comprend, entre l'étape de réalisation des motifs antérieurs et l'étape d'implantation, une étape de dépôt d'une couche de protection recouvrant les motifs antérieurs. Avantageusement, cette couche protège les motifs antérieurs lors de l'implantation. Ces derniers conservent ainsi, lors de l'implantation, les formes et dimensions conférées par l'impression.

- De préférence, la couche de protection est une couche de carbone déposée à partir d'un plasma.

- Selon un mode de réalisation alternatif, la couche sous-jacente est directement au contact de la couche imprimable.

Avantageusement, les paramètres d'implantation, en particulier l'énergie communiquée aux ions, la durée et la dose d'implantation sont prévus de sorte que les zones implantées puissent être gravées sélectivement par rapport aux zones non-implantées. De préférence, ces paramètres d'implantation permettent de faire passer la matière depuis un état cristallin à un état amorphe.

De préférence, l'implantation d'espèces concerne tous les éléments que l'on peut implanter dans le matériau à graver, sans provoquer de dislocation de sa structure atomique telle qu'elle entraînerait une pulvérisation de la matière implantée, sont susceptibles de convenir.

Les ions implantés sont pris parmi l'hydrogène (H2), l'hélium (He), l'argon (Ar) ou l'azote (N2). Une seule ou plusieurs de ces espèces peuvent être implantées.

Selon un mode de réalisation, l'implantation est réalisée de manière anisotrope, selon au moins une direction d'implantation sensiblement perpendiculaire au plan dans lequel s'étend la couche à graver ou un substrat sur lequel est disposée la couche à graver. Sur les figures, la direction privilégiée d'implantation est la direction Z.

Dans le cadre de la présente invention on pourra utiliser les méthodes connues de l'homme du métier et logiciels (SRIM, TRIM, CTRIM...) qui permettent de simuler en fonction des conditions d'implantations l'implantation résultante et notamment la profondeur d'implantation. Parmi les paramètres de l'implantation figurent : la nature de la ou des espèces implantées, le matériau de la couche sous-jacente, le matériau de la couche imprimable, éventuellement le matériau de la couche tampon, dose, énergie, temps d'exposition de la couche implantée au faisceau d'ions.

- Selon un mode de réalisation, ladite gravure des zones modifiées forme au moins une cavité. On introduit au moins un gaz dans ladite cavité. Selon un mode de réalisation, on forme ensuite un bouchon pour obturer une ouverture par laquelle ledit au moins un gaz a été introduit dans la cavité. L'introduction de ce gaz permet de régler les paramètres optiques, électriques, mécanique de la structure. Par ailleurs, la présence de la couche continue permet de confiner de manière fiable et simple ce gaz à l'intérieur de la structure.

- Selon un mode de réalisation, la couche sous-jacente est une couche ou un substrat dont le matériau est pris parmi : le silicium, le silicium germanium, le germanium, le quartz. Selon un mode de réalisation, la couche sous-jacente est une couche mince ou une couche active formée d'un ou plusieurs matériaux conducteurs.

- Selon un mode de réalisation, la couche sous-jacente est une couche ou un substrat dont le matériau est du SiOCH. Le SiOCH peut être poreux ou dense. Ce matériau présente pour avantage d'avoir une très faible permittivité, en particulier lorsqu'il est poreux.

- Selon un mode de réalisation, lors de l'implantation la couche sous-jacente en SiOCH est surmontée d'une couche tampon située entre la couche imprimable et la couche sous-jacente. Selon un mode de réalisation, la couche tampon est en SixNy ou en SixOy, de préférence en SiN ou en SiO2.

- Selon un mode de réalisation, lors de l'implantation la couche tampon présente une épaisseur supérieure ou égale à 10nm et de préférence supérieure ou égale à 20 nm.

- La couche imprimable est formée d'un ou plusieurs matériaux imprimables. Elle est typiquement formée d'une résine imprimable. Selon un mode de réalisation, la couche sous-jacente est directement au contact de la couche imprimable.

- Selon un mode de réalisation, la couche sous-jacente forme la couche active d'une cellule photovoltaïque.

- Selon un mode de réalisation, la couche sous-jacente est un substrat en saphir et forme avec les motifs ultérieurs un substrat de saphir structuré (PSS).

- Selon un mode de réalisation, l'invention porte sur un procédé de fabrication d'une diode à émission de lumière (LED) comprenant un substrat de saphir structuré (PSS), dans lequel le substrat de saphir structuré (PSS) est obtenu par le procédé du paragraphe précédent.

- Selon un mode de réalisation, l'invention porte sur un procédé de fabrication d'une pluralité de cellules photovoltaïques, comprenant un substrat recouvert de motifs, dans lequel les motifs sont obtenus par le procédé selon l'invention.

Il est précisé que dans le cadre de la présente invention, le terme « sur », « surmonte », « recouvre » ou « sous-jacent » ou leurs équivalents ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Dans le cadre de la présente invention, l'épaisseur d'une couche est prise selon une direction perpendiculaire aux faces principales du substrat sur lequel repose les différentes couches. Sur les figures, l'épaisseur est prise selon la direction Z.

Dans le cadre de la présente invention, on désigne par motif en trois dimensions (3D) un motif présentant dans une couche donnée, par exemple une résine ou un substrat, un profil analogique avec une variation continue des tangentes de la forme du profil comme dans la figure 11 ou présentant au moins deux niveaux de profondeur au-dessous de la face supérieure de la couche lorsque le motif est en creux ou au moins deux niveaux de hauteur au-dessus d'une face supérieure de la couche lorsque le motif est en saillie. Un motif dit 2D désigne le cas particulier d'un motif n'ayant que deux niveaux de hauteur ou de profondeur comme dans l'exemple de la figure 1.

La **figure 4** qui est composée des figures 4a à 4d, décrit brièvement les étapes principales du procédé de l'invention qui permet de s'affranchir des problèmes décrits dans l'état de la technique.

Dans une première étape 410 on procède de façon conventionnelle à une opération de nano-impression dans une couche imprimable 110 à l'aide d'un moule (non illustré). Le moule présente des reliefs aux formes possiblement complexes. La couche imprimable 110 est typiquement formée d'une couche de résine imprimable.

De préférence avant impression la couche imprimable 110 a été déposée sur une couche sous-jacente destinée à être graver 120.

La couche sous-jacente est typiquement un substrat 120 ou une couche mince. Dans la suite de la description, par souci de concision et de clarté, on désigne par « substrat 120» cette couche sous-jacente à la couche imprimable 110 et dans laquelle les motifs de la résine vont être transférés. Ce terme n'est aucunement limitatif de la nature et de la fonction de cette couche. Les termes « substrat », « couche à graver » et « couche sous-jacente » sont ainsi équivalents.

Lors de l'opération d'impression on ne cherche pas, comme on le fait dans les techniques de l'art antérieur à minimiser l'épaisseur 130 de la couche résiduelle 131. On s'assure au contraire que cette dernière est d'une épaisseur la plus homogène possible sur l'intégralité de la surface considérée.

Dans une deuxième étape 420 on procède à une implantation 421 d'ions d'éléments gazeux dans le but d'obtenir une modification structurelle du matériau constituant la couche à graver 120 à partir de sa surface.

Les ions utilisés sont pris parmi : l'hydrogène (H), l'argon (Ar), l'azote (N) et l'hélium (He).

L'implantation se fait à travers la couche imprimable 110 préformée par nano-impression. L'implantation se fait donc à différentes profondeurs dans le substrat 120 reproduisant les motifs en relief de la couche imprimable 110 et formant ainsi une zone 122 de matériau modifié.

En effet, la capacité de pénétration des ions dans le matériau de la couche imprimable 110 et dans celui du substrat 120 étant sensiblement identiques, la profondeur de pénétration des ions, mesurée selon la direction d'implantation et en chaque point de la face la couche imprimable 110 par laquelle pénètre les ions est uniforme. Ainsi, la profondeur de pénétration reproduit les motifs de la couche imprimable 110. L'implantation est ainsi conforme, dans le sens où le profil formé par la frontière entre les zones implantées et les zones non implantées reproduit le profil des motifs imprimés dans la couche imprimable.

Par conséquent, les zones dans le substrat 120 sous les régions où l'épaisseur de résine est la plus faible sont modifiées plus en profondeur que les zones où l'épaisseur de résine imprimable est forte.

Selon un autre mode de réalisation on prévoit que les profondeurs de pénétration des ions dans la couche imprimable et dans le substrat sont différentes. Les motifs reproduits dans le substrat ne sont alors pas conformes à ceux de la résine imprimable. Les motifs implantés dans la couche sous-jacente sont alors des homothéties des formes initiales. De préférence, on aura une profondeur de pénétration plus faible pour le substrat (couche sous-jacente) car habituellement la densité du matériau du substrat est plus élevée que la densité du matériau imprimable, donc la pénétration des ions est rendue plus difficile.

La modification obtenue par l'implantation d'ions consiste, par exemple, à rendre amorphe un matériau initialement cristallin. Le matériau rendu amorphe est typiquement du silicium (Si) cristallin très largement utilisé par l'industrie de la microélectronique. L'implantation est réglée pour que les zones de la couche ou substrat 120 sous les zones où l'épaisseur de résine est la plus importante ne soient pas modifiées.

À l'étape suivante 430 on peut alors procéder au retrait de la couche imprimable 110. La méthode de retrait est adaptée au type de résine utilisée. Il peut s'agir d'une gravure dite « humide » c'est-à-dire qu'elle est effectuée dans une solution liquide adaptée qui dissout la résine sans attaquer les couches sous-jacentes. On peut aussi avoir recours à une gravure dite « sèche » à partir d'un plasma formé dans une enceinte confinée. Ces techniques sont bien connues et communément employées par l'industrie de la microélectronique.

La dernière étape 440 du procédé de l'invention consiste à enlever les zones 122 faites de matériau modifié par l'implantation d'ions dans la couche 120. Ce retrait est effectué sélectivement aux zones non modifiée du substrat 120. Les conditions d'implantation et de gravure sont ainsi réglées de manière à ce que la gravure soit sélective des zones modifiée 122 par implantation vis-à-vis des zones non modifiées qui ne sont pas, ou que bien moins, retirées par gravure.

Par exemple, le retrait de ces zones 122 se fait à l'aide d'une gravure humide en utilisant typiquement du tetramethylammonium hydroxide (TMAH) ou encore de l'acide fluorhydrique (HF) sous atmosphère d'oxygène.

Le résultat est comme illustré sur la figure 4d.

À l'issue de ces étapes le profil imprimé dans la résine est transféré dans la couche sous-jacente 120, typiquement un substrat ou une couche mince fonctionnel d'un dispositif en cours de fabrication.

On remarquera ici que le procédé de l'invention ne nécessite pas l'enlèvement de la couche résiduelle 131 de résine avec tous les inconvénients mentionnés dans l'état de la technique. Le seul critère de qualité de cette dernière est son homogénéité en épaisseur (dans le plan X,Y). Or il a été constaté que cette uniformité est d'autant plus facilement obtenue qu'on ne cherche pas à la minimiser. Cette homogénéité d'épaisseur de la couche résiduelle 131 et des reliefs va permettre une reproduction fidèle des motifs imprimés par l'intermédiaire d'une implantation ionique qui se fera alors de manière identique sur toute la surface d'une tranche ou « wafer », l'élément de base à partir duquel les dispositifs microélectronique sont communément produits.

Les paragraphes ci-dessous décrivent un autre avantage directement lié à l'épaisseur résiduelle 131 qui demeure dans le fond des motifs après impression nanométrique.

En effet ce résidu de résine, habituellement perçu comme un inconvénient de la nano-impression, est ici utilisé comme couche de protection protégeant la couche à graver 120 lors de l'implantation. Cette épaisseur résiduelle 131 n'est pas gravée, ou pas entièrement gravée, lors de l'étape d'implantation 421. Au droit des motifs nanoimprimés la couche à graver 120 n'est ainsi pas à nu lors de l'implantation.

Ce mode de réalisation présente un avantage considérable. En effet, il s'est avéré que l'implantation 421 en l'absence d'un résidu d'épaisseur suffisante recouvrant la couche à graver, induit un phénomène qui diminue le contrôle dimensionnel de la forme obtenue au final et qui dégrade la qualité du matériau de résiduel de la couche à graver 120. Plus précisément, en l'absence d'un résidu d'épaisseur suffisante l'implantation recherchée de la couche à graver 120 produit inévitablement un bombardement de la surface de la couche imprimable 110 carbonée. Cette couche de masquage est ainsi pulvérisée en surface. Ce bombardement tend à rayonner des atomes de carbone initialement présents dans la couche imprimable 110. Une partie de ces atomes de carbone est projetée dans la couche à graver 120, là où elle est à nu. Dans le cadre du développement de la présente invention il s'est avéré que ces atomes de carbone pénètrent dans la couche à graver 120 et forment alors dans cette dernière un film de surface enrichi en carbone. Ce film présente généralement une épaisseur inférieure à 20 nm et plus souvent inférieure à 10nm en fonction de l'énergie du bombardement et de la densité du matériau de la couche à graver 120.

Ainsi, la surface de la couche à graver 120 mise à nu est modifiée par apport de carbone. Du fait de cette modification, il n'est alors plus possible de venir correctement graver la zone implantée notamment par gravure humide.

En effet une gravure humide par une solution d'hydroxyde d'ammonium tétraméthyle (TMAH) ou d'acide fluorhydrique (HF) par exemple, ne permettra pas de retirer les zones modifiées par implantation si elles ont été enrichies en carbone. Il s'ensuit que les motifs de la couche imprimable 110 ne sont pas fidèlement reproduits dans la couche à graver 120. En particulier les flancs des motifs de la couche à graver 120 ne sont pas situés au droit de ceux de la couche imprimable 110. Par ailleurs, les flancs des motifs de la couche à graver 120 ne sont pas verticaux.

Le contrôle dimensionnel de la forme complexe à réaliser ainsi que la qualité du matériau résiduel sont donc fortement dégradés.

Dans un cas plus extrême, la solution de gravure ne parvient pas à graver la couche à graver de silicium si la surface de cette dernière a été trop enrichie en carbone.

L'invention, en prévoyant une épaisseur résiduelle 131 qui évite de mettre à nu la couche à graver 120 au droit du motif nano-imprimé de la couche imprimable 110, on parvient à protéger la couche à graver 120 de tout apport de carbone. L'épaisseur 130 de l'épaisseur résiduelle 131 est choisie de manière à ce que les atomes de carbone ne la traverse pas. Cette épaisseur est supérieure à 20 nm et de préférence supérieure à 30nm lors de l'implantation.

La épaisseur résiduelle 131 recouvrant la couche à graver 120 est retirée, par exemple lors de la gravure de la cette dernière.

Les figures et explications qui suivent apportent des précisions supplémentaires sur les étapes du procédé de l'invention et propose des exemples particuliers de mise en oeuvre.

Le substrat ou la couche à graver 120 sont typiquement faits de silicium. Plus généralement tous les substrats cristallins incluant ceux en quartz et en saphir sont susceptibles de bénéficier de l'application du procédé de l'invention. Ceux en silicium présentent par ailleurs comme avantage d'être compatibles avec tous les procédés développés pour les micro et nanotechnologies.

Le matériau constituant la couche 110 qui sert de masque temporaire peut être comme on l'a vu une résine utilisée en lithographie ou un polymère inorganique du type de ceux obtenus par les procédés dits « sol-gel ». Comme discuté dans l'état de la technique la formation des motifs 3D dans la couche 110 utilise traditionnellement la technologie de lithographie par nano impression à partir d'un moule qui contient lui-même les motifs à reproduire. Si le moule est fabriqué dans un matériau non transparent aux longueurs d'ondes de l'ultraviolet (UV), ce qui est le cas d'un moule fait de silicium par exemple, on aura alors recours à un procédé de nano-impression thermique et à l'utilisation d'une résine thermoplastique. L'épaisseur de résine déposée sera déterminée, comme discuté dans le chapitre sur l'état de la technique, par le volume des cavités du moule qu'il faut remplir et en prévoyant que l'épaisseur résiduelle après pressage soit non nulle et au moins égale à une profondeur minimale d'implantation.

Dans le cas de l'utilisation d'un implanteur pour cette opération effectuée à l'étape 420, et comme discuté ci-après, l'épaisseur résiduelle est avantageusement au moins supérieure à 30 nm ce qui permet alors d'implanter les espèces jusqu'à l'interface entre le substrat 120 et la couche imprimable 110, la profondeur minimale d'implantation étant ici d'au moins 30 nm.

Par ailleurs, comme déjà mentionné, on cherche à optimiser le procédé d'impression de telle sorte que l'épaisseur résiduelle soit homogène sur toute la surface imprimée plutôt que de chercher à la minimiser comme c'est le cas pour les procédés de transfert par gravure sèche. Cette phase d'optimisation de l'homogénéité est généralement atteinte lorsque l'épaisseur résiduelle après pressage est plus importante.

Pour le procédé d'impression thermique ce dernier peut être réalisé, par exemple, avec une résine du type PMMA (polyméthacrylate de méthyle), PS (polystyrène), à des pressions de quelques bars à plusieurs dizaines de bars et à des températures de transition vitreuse de la résine (Tg) comprises entre + 10°C et + 100°C. L'étape de démoulage, opération où l'on sépare le moule de la couche de résine, est réalisée à des températures inférieures à ces températures de transition (Tg) de telle sorte que la résine soit alors solide.

Pour l'étape 420 on aura classiquement recours à un implanteur dit à « ligne de faisceau ». Cet équipement comprend une source de production d'ions, un accélérateur de particules utilisant les propriétés électrostatiques de l'ion pour l'accélérer et une chambre pour la cible. Les ions sont ainsi accélérés et dirigés vers la cible où se situe le dispositif à implanter. Dans ce cas, la profondeur implantée peut atteindre plusieurs centaines de nanomètres. Par contre, il est difficile d'implanter en surface car il existe une énergie minimale non nulle fournie aux ions qui est de 1keV (kilo électron volt). Cette énergie minimale provoque inévitablement une pénétration des ions implantés dans le substrat. Les ions se trouvent donc à distance de la surface de ce dernier, même si cela reste à faible profondeur. Il existe ainsi une zone entre la surface et cette profondeur dépourvue ou avec un très faible taux d'espèce implantée. Cela ne permet donc pas qu'une modification en surface, de l'ordre de quelques nanomètres seulement, puisse se faire.

La profondeur minimale d'implantation que l'on peut obtenir dans ces conditions est d'environ 30 nm.

Or, dans le cadre de la présente invention il est nécessaire de pouvoir implanter des ions depuis la surface de la couche sous-jacente 120. Si la profondeur minimale d'implantation est supérieure à l'épaisseur de certaines zones de la couche imprimable, alors la couche sous-jacente ne sera pas modifiée depuis sa surface au droit de ces zones. Plus précisément, une région supérieure de la couche sous-jacente, s'étendant depuis sa surface, ne sera pas modifiée.

Une solution permettant d'utiliser un implanteur classique et de pallier le problème des faibles énergies délivrées par ce type d'équipement est donc de rajouter une « couche tampon » ou « buffer layer » entre les motifs de résine et le substrat de silicium. Cette fonction peut être avantageusement remplie par l'épaisseur résiduelle de résine comme discuté ci-dessus. On choisira donc la couche résiduelle de manière à ce qu'elle soit au moins aussi épaisse que la profondeur minimale de l'implantation si l'on souhaite modifier la couche à graver depuis sa surface.

L'épaisseur de cette couche, qui fait au minimum 30 nm, permet alors d'implanter jusqu'en surface le substrat 120 même avec des ions accélérés avec une énergie de seulement 1 keV. Dans ce type de réacteur, l'implantation est réalisée à une profondeur donnée, généralement notée Rp. Autour de cette profondeur Rp, la zone d'implantation s'étend typiquement sur quelques dizaines de nanomètres selon la direction d'implantation. Pour obtenir une modification continue du substrat, depuis sa surface jusqu'à la profondeur souhaitée, il est alors nécessaire d'assurer un recouvrement des profondeurs modifiées du substrat après chaque étape d'implantation.

Un exemple des résultats d'une opération d'implantation effectuée à l'étape 420 est illustré par la **figure 7.** Cette implantation est appliquée à l'empilement de couches illustré en **figure 5.**

L'empilement comprend successivement un substrat 120, une couche tampon 510 et une couche imprimable 110. Dans cet exemple la couche tampon 510 est faite de SiARC, un matériau anti réfléchissant couramment utilisé en lithographie. Elle est dans ce cas d'une épaisseur de 100 nm pour une implantation dans le silicium constituant le substrat qui s'étend 520 sur une profondeur de 350 nm. Un résultat similaire serait obtenu avec 100 nm d'épaisseur résiduelle de résine obtenue après impression des motifs 3D dans la couche 110 comme avec la structure de la figure 4a.

Comme on le voit sur la figure 7 on procède dans cet exemple à cinq implantations successives d'ions hydrogène (H) avec des énergies entre 5 et 25 keV et une même dose de $10^{15}$ atomes/cm$^2$. Les conditions sont calculées pour qu'il y ait recouvrement des profils d'implantation. Les implantations sont obtenues à des profondeurs et avec des recouvrements comme indiqué dans le tableau 530.

L'étape de retrait de la couche imprimable 110 est ensuite réalisée par exemple dans une chambre de gravure en utilisant une chimie à base d'oxygène ou par voie humide en utilisant une chimie couramment utilisée par l'homme du métier employant un mélange dit SPM d'acide sulfurique (H2SO4) combiné au peroxyde d'hydrogène ou eau oxygénée (H2O2). Cette étape est parfaitement connue et maitrisée par l'homme du métier.

On notera que pour accéder aux zones modifiées 122 enterrées sous la couche non modifiée 127, il peut être utile de pratiquer des ouvertures 123. La solution de gravure est introduite par ces ouvertures.

Les conditions de retrait de la couche modifiée doivent être telles que ce procédé ne doit pas ou peu consommer le matériau non modifié c'est-à-dire pas plus de quelques nanomètres par minute. Typiquement, le substrat est fait de silicium et il s'agit de retirer dans les conditions décrites le silicium rendu amorphe par l'implantation sélectivement au silicium cristallin. Comme déjà mentionné, l'utilisation de tetramethyl ammonium hydroxide, amoniac (TMAH) ou d'acide fluorhydrique (HF) sous atmosphère d'oxygène est particulièrement avantageuse. Le silicium cristallin n'est en effet pas ou peu consommé par ce type de nettoyage.

La **figure 6** composée des figures 6a à 6e décrit une variante de mise en oeuvre du procédé dans laquelle, après l'étape 410, où l'on vient former les motifs 3D dans la couche imprimable 110, et avant l'étape d'implantation 420, on insère une étape supplémentaire 415 au cours de laquelle, comme montré sur la figure 6b, on effectue un dépôt d'une couche de protection recouvrant les motifs antérieurs formés dans la couche imprimable et protégeant ces motifs lors de l'implantation. Cette couche de protection est avantageusement une couche de carbone 115. L'épaisseur déposée est de quelques nanomètres. Typiquement, de 1 à 5 nanomètres de carbone sont déposés. Cette opération peut être réalisée dans une chambre de dépôt ou de gravure dans laquelle on crée un plasma par exemple à base de méthane ($CH_4$). La couche de carbone 115 peut s'avérer nécessaire pour protéger la surface du matériau imprimé par nano impression, avantageusement de la résine, et ainsi limiter la consommation de cette dernière lors de l'étape d'implantation 420 qui suit. Dans le cas de l'utilisation d'une chambre de gravure pour cette opération on peut avoir recours, par exemple, à un réacteur à couplage capacitif (CCP) ou inductif (ICP). Ce type de dépôt bien connu de l'homme du métier peut être obtenu d'une façon générale en utilisant des gaz de type hydrocarbure ($C_xH_y$) ou fluorure de carbone ($C_xF_y$).

Le retrait de la couche de carbone 115 peut par exemple être effectué par plasma à base d'Oxygène.

Une variante supplémentaire du procédé de l'invention, illustrée par la **figure 8** composée des figures 8a à 8c, permet de réaliser des structures 3D enterrées dont les propriétés, par exemple électriques, optiques, magnétiques et thermiques, sont modifiées. Cette variante comprend les étapes suivantes:

- Comme illustré par la figure 8a on procède comme précédemment à une nano-impression de formes complexes dans un matériau imprimable 110. Comme indiqué ci-dessus, de préférence on ne cherche pas à minimiser l'épaisseur de la couche résiduelle 131 afin de s'assurer que cette dernière soit homogène sur l'intégralité de la surface considérée.
- Ensuite, comme illustré sur la figure 8b, on réalise une implantation d'ions, par exemple des ions hydrogène, au travers de la couche imprimable 110 préformée par nano-impression, à différentes profondeurs et avec recouvrement comme expliqué dans la figure 5, dans la couche sous-jacente 120, c'est-à-dire le substrat ou la couche mince à structurer. Les zones dans la couche sous-jacente 120 sous les régions ou l'épaisseur de résine est la plus faible seront modifiées plus en profondeur. Le matériau de la couche sous-jacente 120 sera modifié par implantation, comme déjà mentionné, par exemple en le rendant amorphe alors qu'il est initialement cristallin. Les zones du substrat sous les zones où l'épaisseur de résine est la plus importante ne sont pas modifiées par l'implantation. Les implantations sont réglées dans ce cas pour que la zone modifiée par l'implantation la plus proche de l'interface avec l'air c'est-à-dire l'interface substrat/résine ou couche/résine soit enterrée d'une épaisseur prédéterminée 126 de telle sorte qu'elle ne pourra être retirée du substrat ou de la couche par un procédé sec ou humide. Ainsi, au terme de l'implantation, la couche sous-jacente 120 présente une région 127 non modifiée, continue à la surface de la couche sous-jacente 120 et qui s'étend depuis la surface de cette même couche 120 et dans la direction d'implantation.

Plus précisément, la couche à graver 120 présente une zone non modifiée entre chaque zone modifiée 122 par implantation et la face 128 supérieure de cette couche à graver 120. Ainsi aucune zone modifiée 122 par implantation ne s'étend depuis la face 128 supérieure de cette couche à graver 120. La face 128 supérieure de cette couche à graver 120 est la face qui est tournée au regard de la couche imprimable et au travers de laquelle pénètrent les ions lors de l'implantation 421.

Cette zone 127 est donc continue selon l'épaisseur de l'empilement, soit selon la direction z du repère illustré en figure 4a. Cette zone 127 non modifiée s'étend de préférence sur toute la surface de la couche à graver 120. Alternativement elle ne s'étend que sur une partie seulement de la face 128 supérieure de la couche à graver 120. Selon un mode de réalisation elle s'étend au droit de certaines seulement des zones modifiées 122.

L'épaisseur 126 de la zone 127 non modifiée continue n'est pas nécessairement constante sur toute la surface de la couche à graver 120. Sur l'exemple illustré en figure 8b cette épaisseur est constante.

De préférence cette épaisseur 126 est supérieure ou égale à 10nm et de préférence supérieure ou égale à 20nm, de préférence supérieure ou égale à 30nm et de préférence supérieure ou égale à 40nm.

Ainsi les zones modifiées 122 sont toutes situées à distance de la face 128 supérieure de la couche à graver 120.

Ainsi la profondeur minimale d'implantation est supérieure à l'épaisseur de la couche résiduelle. Cette couche non modifiée permet d'encapsuler les motifs formés par l'implantation.

- Comme illustré sur la figure 8c on procède ensuite au retrait du matériau préalablement nano-imprimé 110 avec des procédés secs et/ou humides, comme déjà décrit, sans affecter la zone modifiée qui est enterrée.

On obtient ainsi des zones modifiées 122 encapsulées dans le matériau non modifié de la couche sous-jacente 120.

Les zones modifiées 122 sont ultérieurement retirées sélectivement par rapport au matériau non modifié. Pour cela on réalise des ouvertures 123 pour accéder à ces zones, comme illustré en figure 8c.

Dans ce cas les motifs formés par les zones non modifiées sont alors entourés, au moins partiellement, de vide ou de gaz. Le gaz peut être de l'air ambiant. Il peut aussi s'agir d'un gaz injecté dans la cavité formée par le retrait des zones modifiées 122. En effet, du gaz peut être injecté par l'entrée ayant servi à la gravure des zones modifiées. Les motifs formés par les zones non modifiées présentent alors au moins l'une de leurs propriétés optiques, électriques, magnétiques, thermiques ou mécaniques qui est différente de celle du gaz qui les environne.

Dans le cas où l'on injecte un ou plusieurs gaz dans la ou les cavités, il faut à l'issue de l'injection fermer les ouvertures 123 ayant servi à la gravure des zones modifiées et à l'injection du gaz. Par exemple on pourra déposer une résine à la tournette (par spin coating) qui vient alors boucher les ouvertures 123. Cette résine est de préférence exposée à une source de lumière pour la stabiliser à l'endroit de l'ouverture 123 et le reste de la résine non exposée est retiré par un traitement bien connu de l'homme du métier. On forme ainsi un bouchon à l'endroit des ouvertures 123.

Ces zones sont ensuite retirées sélectivement par rapport au matériau non modifié, après avoir réalisé des ouvertures pour accéder à ces zones.

Les procédés de l'invention décrits dans les figures précédentes pourront avantageusement être appliqués à la fabrication de cellules photovoltaïques permettant de définir une méthode de réalisation qui va améliorer leur rendement par l'intermédiaire d'une réduction de la réflectivité du substrat. Ceci est illustré sur la **figure** 9 qui est composée des figures 9a à 9e.

De manière similaire aux procédés conventionnels l'invention va permettre en effet de réaliser une structuration pyramidale de surface du substrat mais avec des formes plus prononcées que ce qu'on peut obtenir avec une gravure humide standard. Cette structure est illustrée pour comparaison par la photo de la figure 9a.

Pour déterminer les formes optimales à utiliser pour la fabrication de cellules solaires, des simulations optiques ont été réalisées afin de calculer la réflectivité de la surface d'un substrat structuré à l'aide des procédés de l'invention. La réflectivité de surface est calculée sous la forme d'un coefficient de réflexion en utilisant un logiciel standard comme celui de la société « Zemax » sur la base d'une méthode dite de « tracé de rayons » de l'anglais « ray-tracing » et en faisant appel à la loi dite de « Snell-Descartes » considérant les rayons réfléchis, possiblement de multiples fois, les rayons transmis et ceux absorbés comme représenté 1120 sur la figure 9b. On peut alors calculer le coefficient de réflexion d'une telle surface à l'aide d'un logiciel externe à l'aide de matrices dite d'Abelès. Le résultat est comme montré sur la figure 9c qui donne le pourcentage de réflectivité en fonction de l'angle de la pyramide 1110 noté a.

La structure pyramidale standard, celle obtenue avec une gravure humide qui permet d'obtenir un angle 1110 de 54,7 degrés, et qui correspond à la figure 9a, présente une réflectivité 1140 de 12 à 13%. Le graphe de la figure 9c montre que la réflectivité est d'autant meilleure que l'angle $\alpha$ est plus élevé. Avec les procédés de l'invention on parvient à réaliser une structure pyramidale avec un angle supérieur à celui qui peut être obtenu par gravure humide du silicium c'est-à-dire supérieur à 54,7 degrés. Ainsi la réflectivité du substrat est diminuée et par conséquent le gain de la cellule augmenté. Les figures 11d et 11e montre une image d'une telle structure qui présente un angle de 75 degrés, obtenu respectivement, dans du silicium monocristallin (c-Si) ou du silicium multi cristallin (mc-Si).

La gravure humide du silicium cristallin avec ce type de chimie TMHA ou KOH s'arrête sur les plans cristallins 111 qui sont orientés à 54.7 pour le silicium 100

Le gain en réflectivité est significatif et chute de 14% à 2 voire 3 % 1140 comme montré sur la figure 9c. On notera ici que pour les structures des figures 9d et 9e la période de répétition des motifs pyramidaux est avantageusement supérieure à la gamme des longueurs d'ondes visibles c'est-à-dire supérieure à 800 nm.

L'obtention de motifs pyramidaux avec des pentes à 75° se fait avantageusement comme décrit ci-après. On réalise tout d'abord à l'aide d'une gravure humide (KOH, TMAH) sur un premier substrat en silicium des pyramides inversées avec des pentes à 54,7°. Ce premier substrat constitue un premier moule modèle de lithographie par nano impression. On notera que la surface du silicium est traitée avec un agent anti adhésif, une technique bien connue de l'homme du métier. Le moule modèle permet d'imprimer une résine déposée sur un substrat dans laquelle on obtient des pyramides inversées qui présentent donc une pente de 54.7°. Ces motifs sont transférés par gravure sèche dans le substrat sous-jacent. En ajustant la vitesse de gravure de la résine et du substrat on peut transférer des pyramides inversées présentant une pente plus importante qui est typiquement de 75°. On obtient alors un second substrat dont les motifs pyramidaux ont la pente souhaitée. On applique ensuite sur ce second substrat, comme précédemment, un traitement anti adhésif afin d'obtenir un nouveau moule modèle qui est utilisé à son tour pour imprimer des pyramides à 75° dans la résine. Ce masque de résine est utilisé comme décrit dans le procédé de l'invention pour transférer rapidement par implantation dans le substrat à graver des motifs pyramidaux présentant une pente de 75°.

La **figure 10** composée des figures 10a et 10b montre que l'on peut également utiliser un autre type d'arrangement que celui pyramidal à base carrée des figures précédentes. Les figures ci-dessus comparent des vues de dessus d'un autre exemple de formes élémentaires, hexagonales dans cet exemple, avec la forme pyramidale précédente. Le choix de la forme et l'organisation optimale se feront en utilisant un logiciel dit de « tracé de rayon optique » comme décrit ci-dessus et en calculant la réflectivité.

Un autre champ d'application de l'invention concerne la réalisation de substrats de saphir structurés pour la fabrication de dispositifs LED c'est-à-dire de « diodes à émission de lumière » de l'anglais « light emitting diodes ». Ces substrats structurés sont généralement désignés par leur acronyme PSS de l'anglais « patterned sapphire substrate ».

Dans l'industrie des LEDs, la structuration de surface de substrats, et notamment de substrats de saphir, qui requiert des étapes spécifiques de lithographie et de gravure, est cruciale pour l'obtention d'une meilleure efficacité de conversion permettant d'obtenir en effet jusqu'à 30 à 35% d'amélioration du rendement lumineux.

Les étapes de gravure qui permettent d'obtenir cette structuration sont relativement longues, de l'ordre de 30 minutes par tranche d'un diamètre de 100 millimètres. Par ailleurs, la gravure des substrats de saphir pour les LED haute brillance (HD-LED) est une opération entraînant la génération de nombreux résidus solides et une utilisation intensive des équipements, typiquement pendant 80% du temps de production. Les verrous technologiques à prendre en compte pour pouvoir adresser ce marché sont : la qualité des équipements, la performance des systèmes de chargement/déchargement des substrats ; les coûts de maintenance.

Pour structurer en surface les substrats de saphir des techniques conventionnelles de structuration 2D à l'aide d'une lithographie UV sont communément utilisé de façon industrielle. Une technique standard est illustrée sur la figure 11a pour comparaison avec le procédé de l'invention dont les étapes sont illustrées sur la figure 11b.

Avec la technique conventionnelle, la résine exposée est gravée de manière isotrope pour contrôler la forme finale avant gravure anisotrope dans le saphir. La résine est ensuite retirée afin de laisser le substrat de saphir structuré avant croissance de nitrure de gallium (GaN). La tendance actuelle est de structurer des tranches ou « wafers » de saphir de plus en plus grands : de 4, 6 et 8 pouces. La lithographie UV avec des masques qu'il faut aligner à l'aide de « mask aligners » répond mal au problème de planéité et l'apparition de défauts dits de « bow » et de « warp » avec ces substrats de grandes tailles. Une solution possible est d'utiliser pour réaliser ces structurations des « steppers », appareillages classiques de photolithographie où l'on vient répéter sans contact des images des motifs à reproduire, générant cependant des coûts de production supplémentaires très importants. Un candidat à la structuration de substrats de grandes surfaces non-plan est la nano-impression permettant de structurer un polymère en trois dimensions en une seule étape.

On peut alors mettre en oeuvre les procédés de l'invention décrits précédemment. On forme tout d'abord dans la couche imprimable 110 des motifs coniques 1410. Puis on procède à l'implantation du substrat en saphir à travers la couche imprimable 110 portant les motifs.

Après retrait de la couche imprimable 110 et retrait des zones modifiées par l'implantation du substrat en saphir on obtient bien un transfert de ces formes coniques dans le saphir 1420.

Le procédé selon l'invention permet d'améliorer la précision des formes coniques obtenues.

Comme indiqué ci-dessus l'invention est particulièrement avantageuse dans le cas où la couche sous-jacente 120 est en silicium ou dans l'un des matériaux suivants : le silicium germanium, le germanium, le nitrure de silicium, le saphir, le quartz, ce dernier étant cristallin.

Selon encore un autre mode de réalisation la couche à graver est en oxyde de silicium carboné et hydrogéné (SiOCH). Il peut s'agir de SiOCH poreux ou dense. Ce matériau présente pour avantage d'avoir une très faible permittivité, en particulier lorsqu'il est poreux.

Tous les modes de réalisation décrits ci-dessus sont applicables au SiOCH. Les étapes principales d'un mode de réalisation particulièrement avantageux vont être décrites ci-dessous en référence aux figures 12a à 12e.

1. Empilement (figure 12a): Une couche de résine formant la couche imprimable 110 est déposée sur une couche sous-jacente 120 de SiOCH qui peut elle-même reposer sur un substrat 121, par exemple en silicium. Entre la couche imprimable 110 et la couche 120 de SiOCH on forme une couche tampon 510, par exemple un oxyde (SiO2) ou plus généralement SixOy ou un nitrure (SiN) ou plus généralement SixNy. Cette couche tampon 510 sera utilisée pour faciliter la lithographie comme cela sera explicité ci-dessous. Elle fait également office de couche tampon pour protéger le SiOCH lors de l'implantation, ce matériau étant de faible densité il est facilement pulvérisé pendant l'implantation.

2. Lithographie (figure 12b): on effectue une étape de lithographie par nano-impression (NIL). Après pressage du moule 100 il subsiste dans le fond des motifs un résidu de résine 131 présentant une épaisseur 130. Par ailleurs, comme cela a été décrit ci-dessus, l'épaisseur résiduelle 131 forme une couche permettant de stopper les atomes de carbone arrachés à la surface de la couche de résine 110 et qui ont tendance à pénétrer dans la couche sous-jacente 120 de SiOCH.

3. Implantation (figure 12c): L'implantation 421 est réalisée à travers la couche imprimable 110 et donc, au droit des motifs, à travers l'épaisseur résiduelle 131 et la couche tampon 510. L'implantation 421 peut être réalisée dans un équipement d'implantation ionique à faisceau d'ions ou à immersion plasma. L'énergie et la dose d'implantation sont définies en fonction du profil et de la profondeur souhaités. Des simulations sur appliquette Crystal TRansport of Ions in Mater (C-trim) permettent de prédire la profondeur d'implantation dans les matériaux.

L'implantation ionique engendre des modifications dans le matériau, notamment la rupture de certaines liaisons. Sous l'effet de l'implantation, le SiOCH perd ses groupements méthyle et tend vers une structure proche de ou semblable à celle d'un SiO2. Ceci permet de créer une forte sélectivité lors de la gravure humide.

Dans le cadre de la présente invention il a été remarqué que, quelle que soit l'espèce de l'ion implanté, une pulvérisation du SiOCH a lieu. L'intégration de la couche tampon 510 citée précédemment s'avère alors particulièrement avantageuse.

Dans le cadre du développement de la présente invention, l'Hydrogène s'est avéré particulièrement avantageux. L'hydrogène permet en effet d'avoir une sélectivité très forte quand d'autres espèces telles que l'Argon manifestent une résistance « infinie » à la gravure humide au HF.

La **figure 13** illustre la structure du SiOCH après l'implantation d'H et d'Ar. La dose étant toujours maintenue à 1.E15at/cm$^2$, trois énergies sont testées pour l'Hydrogène 1kev, 10kev, et 100kev, et une pour l'Argon : 10kev.

Sur la figure 13, la courbe 132 correspond à du SiOCH de référence c'est-à-dire non implanté ; la courbe 133 correspond à du SiOCH implanté avec des ions hydrogène et une énergie de 1keV ; la courbe 134 correspond à du SiOCH implanté avec des ions hydrogène et une énergie de 10keV ; la courbe 135 correspond à du SiOCH implanté avec des ions hydrogène et une énergie de 100keV ; la courbe 136 correspond à du SiOCH implanté avec des ions argon et une énergie de 10keV.

On remarque dans le cas de l'H, l'apparition de la liaison O-H (bande 2800-3800 cm-1) après implantation ce qui correspond à la prise d'eau du matériau, le SiOCH passe d'un matériau hydrophobe à un matériau hydrophile. La prise d'eau reste peu prononcée pour l'Argon ce qui explique sa résistance à la gravure humide au HF.

On constate également la rupture des groupements méthyle et la formation des liaisons Si-O.

4. Retrait de la couche de masquage (figure 12d): Le retrait de la couche imprimable 110 en résine peut se faire par voie humide ou sèche. Lors de cette étape la couche tampon 510 protège avantageusement le SiOCH.

5. Gravure du SiOCH modifié (figure 12e): Cette étape de gravure est de préférence effectuée avec une solution d'HF diluée à 1%. Comme expliqué précédemment l'implantation génère des modifications dans le SiOCH qui se traduisent par l'hydrophilisation du matériau, la rupture des groupements méthyle et enfin la formation des liaisons Si-O. Ceci permet d'avoir une sélectivité infinie par rapport à la zone non modifiée à hauteur d'un temps de gravure inférieur à 240 secondes.

La figure 14 indique l'épaisseur de SiOCH gravée en fonction du temps de gravure, par une solution HF diluée à 1%, pour différentes espèces implantées dans le SiOCH et pour du SiOCH non implanté. Les courbes 141, 142, 143, 144, 145, 146, 147, 148 correspondent à du SiOCH modifié par implantation respectivement des espèces suivantes : Ar, F, H2+O, H2, H, C, O. La courbe 148 correspond à la gravure par la solution du SiOCH non implanté.

Cette étape permet également le retrait de la couche tampon 510, par exemple en SiN ou SiO2.

La technique décrite ci-dessus pour texturer du SiOCH présente plusieurs avantages :

- Le masque formé par la couche imprimable 110 n'est pas métallique mais organique ce qui confère de nombreux avantages en termes de procédé.
- La lithographie par nano-impression utilisée pour créer le motif est peu coûteuse et précise. Par ailleurs le résidu de résine dans le fond du motif peut faire office de couche de protection pour protéger la couche de SiOCH contre l'apport non souhaité de carbone lors de l'implantation comme cela a été décrit ci-dessus. Par ailleurs, elle protège le SiOCH lors du retrait de la résine.
- La gravure se fait par voie humide ce qui permet de conserver un contrôle dimensionnel et un état de surface meilleur qu'avec des gravures sèches.

Selon un mode de réalisation alternatif, l'enlèvement de la couche de masquage 110 en résine peut être fait lors de l'étape de gravure humide par solution HF, en particulier si l'on utilise une résine à base de Silicium comme l'Hydrogène silsesquioxane (HSQ).

L'invention n'est pas limitée aux modes de réalisations précédemment décrits et s'étend à tous les modes de réalisation couverts par les revendications.

**Revendications**

1. Procédé de réalisation de motifs ultérieurs, en creux ou en saillie, dans une couche sous-jacente (120), le procédé comprenant au moins :

   - une étape de réalisation de motifs antérieurs dans une couche imprimable (110) carbonée surmontant la couche sous-jacente (120), dans lequel la réalisation des motifs antérieurs comprend une impression nanométrique de la couche imprimable (110),

- au moins une étape de modification de la couche sous-jacente (120) par implantation (421) d'ions au sein de la couche sous-jacente (120), l'implantation (421) étant réalisée au travers de la couche imprimable (110), les paramètres de l'implantation (421) comprennent notamment une direction d'implantation (421) et dans lequel la direction d'implantation (421) est perpendiculaire à un plan principal dans lequel s'étend la couche sous-jacente (120), les paramètres de l'implantation (421) étant choisis de manière à former dans la couche sous-jacente (120) des zones modifiées (122) par l'implantation (421) et des zones non implantées, les zones non implantées définissant les motifs ultérieurs et présentant une géométrie qui est fonction des motifs antérieurs, les ions étant pris parmi les ions : hydrogène ($H_2$), hélium (He), argon (Ar) ou azote (N2)

- après l'étape de modification, au moins une étape de retrait par gravure des zones modifiées (122) par implantation, de manière sélective par rapport aux zones non implantées, de manière à laisser en place les zones non implantées définissant les motifs ultérieurs,

**caractérisé en ce que:**

l'étape de réalisation des motifs antérieurs dans la couche imprimable (110) carbonée laisse en place dans le fond des motifs des épaisseurs résiduelles (131) de couche imprimable (110), la couche imprimable (110) formant alors une couche continue recouvrant la couche sous-jacente (120), l'implantation étant réalisée au travers de la couche imprimable (110) comprenant les motifs antérieurs et lesdites épaisseurs résiduelles (131),
et **en ce que** l'épaisseur résiduelle (131) dans le fond des motifs est supérieure ou égale à 20 nanomètres ($10^{-9}$ mètres) et de préférence supérieure ou égale à 30 nm et est suffisante pour former une barrière qui piège des atomes de carbone arrachés à la couche imprimable (110) carbonée lors de ladite implantation (421) de manière à empêcher ces atomes de pénétrer à l'intérieur de la couche sous-jacente (120).

2. Procédé selon la revendication précédente dans lequel les matériaux de la couche imprimable (110) et de la couche sous-jacente (120) ainsi que les paramètres de l'implantation (421), notamment la nature des ions, sont choisies de manière à ce que les matériaux de la couche imprimable (110) et de la couche sous-jacente (120) présentent des capacités de pénétration des ions identiques.

3. Procédé selon la revendication précédente dans lequel les paramètres de l'implantation (421) sont choisis de manière à ce que les motifs ultérieurs présentent une géométrie identique à celle des motifs antérieurs.

4. Procédé selon l'une quelconque des revendications précédentes dans lequel la gravure est une gravure par voie humide ou par voie sèche.

5. Procédé selon l'une quelconque des revendications précédentes dans lequel l'étape de réalisation de motifs antérieurs est réalisée de manière à ce que pour chacun des motifs l'épaisseur résiduelle (131) de la couche imprimable (110) soit supérieure à la profondeur minimale d'implantation (421) des ions, la profondeur minimale étant prise selon la direction d'implantation (421) et à partir de la surface de la couche imprimable (110).

6. Procédé selon l'une quelconque des revendications 1 à 4 dans lequel l'étape de réalisation de motifs antérieurs est réalisée de manière à ce que pour chacun des motifs l'épaisseur résiduelle (131) de la couche imprimable (110) soit inférieure à la profondeur minimale d'implantation (421) des ions, la profondeur minimale étant prise selon la direction d'implantation (421) et à partir de la surface de la couche imprimable (110).

7. Procédé selon l'une quelconque des revendications précédentes comprenant, entre l'étape de réalisation des motifs antérieurs et l'étape d'implantation (421), une étape de dépôt d'une couche de protection recouvrant les motifs antérieurs.

8. Procédé selon la revendication précédente dans lequel la couche de protection est une couche de carbone déposée à partir d'un plasma.

9. Procédé selon l'une quelconque des revendications précédentes dans lequel la couche sous-jacente (120) est une couche ou un substrat dont le matériau est pris parmi : le silicium, le silicium germanium, le germanium, le quartz.

10. Procédé selon l'une quelconque des revendications 1 à 8 dans lequel la couche sous-jacente (120) est une couche ou un substrat dont le matériau est du SiOCH.

11. Procédé selon la revendication précédente dans lequel lors de l'implantation (421) la couche sous-jacente (120) en SiOCH est surmontée d'une couche tampon (510) située entre la couche imprimable (110) et la couche sous-jacente (120).

**12.** Procédé selon la revendication précédente dans lequel la couche tampon (510) est en SixNy ou en SixOy, de préférence en SiN ou en SiO$_2$.

**13.** Procédé selon l'une quelconque des deux revendications précédente dans lequel lors de l'implantation (421) la couche tampon (510) présente une épaisseur supérieure ou égale à 10nm et de préférence supérieure ou égale à 20 nm.

**14.** Procédé selon l'une quelconque des revendications 1 à 8 dans lequel la couche sous-jacente (120) forme la couche active d'une cellule photovoltaïque ou dans lequel la couche sous-jacente (120) est un substrat en saphir et forme avec les motifs ultérieurs un substrat de saphir structuré (PSS).

**15.** Procédé de fabrication d'une diode à émission de lumière (LED) comprenant un substrat de saphir structuré (PSS), dans lequel le substrat de saphir structuré (PSS) est obtenu par le procédé de la revendication précédente.

**Patentansprüche**

**1.** Verfahren zum Erzeugen späterer, einspringender oder vorstehender Motive in einer darunterliegenden Schicht (120), wobei das Verfahren mindestens Folgendes umfasst:

- einen Schritt zum Erzeugen früherer Motive in einer bedruckbaren Kohlenstoffschicht (110), welche sich über der darunterliegenden Schicht (120) erhebt, wobei das Erzeugen früherer Motive ein nanometrisches Bedrucken der bedruckbaren Schicht (110) umfasst;
- mindestens einen Schritt zum Modifizieren der darunterliegenden Schicht (120) durch Implantieren (421) von Ionen innerhalb der darunterliegenden Schicht (120), wobei das Implantieren (421) durch die bedruckbare Schicht (110) hindurch vorgenommen wird, wobei die Parameter für das Implantieren (421) insbesondere eine Implantierungsrichtung (421) umfassen, und wobei die Implantierungsrichtung (421) senkrecht zu einer Hauptebene verläuft, in der sich die darunterliegende Schicht (120) erstreckt, wobei die Parameter für das Implantieren (421) derart ausgewählt werden, um in der darunterliegenden Schicht (120) durch das Implantieren (421) modifizierte Zonen (122) und nicht implantierte Zonen zu bilden, wobei die nicht implantierten Zonen die späteren Motive definieren und eine Geometrie aufweisen, die von den früheren Motiven abhängig ist, wobei die Ionen unter den folgenden Ionen angenommen werden: Wasserstoff (H$_2$), Helium (He), Argon (Ar) oder Stickstoff (N$_2$)
- nach dem Schritt des Modifizierens mindestens einen Schritt des Entfernens durch Ätzen der durch das Implantieren modifizierten Zonen (122) auf selektive Art und Weise in Bezug auf die nicht implantierten Zonen, um die nicht implantierten Zonen, die die späteren Motive definieren, an Ort und Stelle zu belassen,

**dadurch gekennzeichnet, dass:**

der Schritt zum Erzeugen der früheren Motive in einer bedruckbaren Kohlenstoffschicht (110) am Boden Motive mit den Restdicken (131) einer bedruckbaren Schicht (110) an Ort und Stelle belässt, wobei die bedruckbare Schicht (110) somit eine durchgehende Schicht bildet, die die darunterliegende Schicht (120) abdeckt, wobei das Implantieren, das durch die bedruckbare Schicht (110) hindurch vorgenommen wird, die früheren Motive und die Restdicken (131) umfasst,
und dadurch, dass die Restdicke (131) am Boden der Motive größer oder gleich 20 Nanometer (10$^{-9}$ Meter), und vorzugsweise größer oder gleich 30 nm beträgt, und ausreichend ist, um eine Barriere zu bilden, die Kohlenstoffatome auffängt, die der bedruckbaren Kohlenstoffschicht (110) beim Implantieren (421) entrissen worden sind, um zu verhindern, dass diese Atome ins Innere der darunterliegenden Schicht (120) eindringen.

**2.** Verfahren nach dem vorstehenden Anspruch, wobei die Werkstoffe der bedruckbaren Schicht (110) und der darunterliegenden Schicht (120), sowie die Parameter für das Implantieren (421), insbesondere die Art der Ionen, derart ausgewählt werden, dass die Werkstoffe der bedruckbaren Schicht (110) und der darunterliegenden Schicht (120) identische Eindringvermögen für die Ionen aufweisen.

**3.** Verfahren nach dem vorstehenden Anspruch, wobei die Parameter für das Implantieren (421) derart ausgewählt werden, dass die späteren Motive eine Geometrie aufweisen, die gleich jener der früheren Motive ist.

**4.** Verfahren nach einem der vorstehenden Ansprüche, wobei das Ätzen Nassätzen oder Trockenätzen ist.

**5.** Verfahren nach einem der vorstehenden Ansprüche, wobei der Schritt zum Erzeugen früherer Motive derart vorgenommen wird, dass bei jedem der Motive die Restdicke (131) der bedruckbaren Schicht (110) größer als die Mindesttiefe für das Implantieren (421) der Ionen ist, wobei die Mindesttiefe entlang der Implantierungsrichtung (421) und ausgehend von der Oberfläche der bedruckbaren Schicht (110) angenommen wird.

6. Verfahren nach einem der Ansprüche 1 bis 4, wobei der Schritt zum Erzeugen früherer Motive derart vorgenommen wird, dass bei jedem der Motive die Restdicke (131) der bedruckbaren Schicht (110) kleiner als die Mindesttiefe für das Implantieren (421) der Ionen ist, wobei die Mindesttiefe entlang der Implantierungsrichtung (421) und ausgehend von der Oberfläche der bedruckbaren Schicht (110) angenommen wird.

7. Verfahren nach einem der vorstehenden Ansprüche, das zwischen dem Schritt zum Erzeugen der früheren Motive und dem Schritt des Implantierens (421) einen Schritt des Abscheidens einer Schutzschicht, die die früheren Motive abdeckt, umfasst.

8. Verfahren nach dem vorstehenden Anspruch, wobei die Schutzschicht eine Kohlenstoffschicht ist, die ausgehend von einem Plasma abgeschieden wird.

9. Verfahren nach einem der vorstehenden Ansprüche, wobei die darunterliegende Schicht (120) eine Schicht oder ein Substrat ist, dessen Werkstoff aus Folgenden angenommen wird: Silicium, Siliciumgermanium, Germanium, Quarz.

10. Verfahren nach einem der Ansprüche 1 bis 8, wobei die darunterliegende Schicht (120) eine Schicht oder ein Substrat ist, dessen Werkstoff SiOCH ist.

11. Verfahren nach dem vorstehenden Anspruch, wobei sich beim Implantieren (421) eine Pufferschicht (510), die sich zwischen der bedruckbaren Schicht (110) und der darunterliegenden Schicht (120) befindet, über der darunterliegenden Schicht (120) aus SiOCH erhebt.

12. Verfahren nach dem vorstehenden Anspruch, wobei die Pufferschicht (510) aus SixNy oder aus SixOy, vorzugsweise aus SiN oder aus SiO$_2$ besteht.

13. Verfahren nach einem der beiden vorstehenden Ansprüche, wobei beim Implantieren (421) die Pufferschicht (510) eine Dicke größer oder gleich 10 nm, und vorzugsweise größer oder gleich 20 nm aufweist.

14. Verfahren nach einem der Ansprüche 1 bis 8, wobei die darunterliegende Schicht (120) die aktive Schicht eine Photovoltaikzelle bildet, oder wobei die darunterliegende Schicht (120) ein Substrat aus Saphir ist, und mit den späteren Motiven ein strukturiertes Saphirsubstrat (PSS) bildet.

15. Verfahren zum Herstellen einer Leuchtdiode (LED), umfassend ein strukturiertes Saphirsubstrat (PSS), wobei das strukturierte Saphirsubstrat (PSS) durch das Verfahren nach dem vorstehenden Anspruch erhalten wird.

## Claims

1. A method for making recessed or projecting subsequent patterns in an underlayer (120), the method comprising at least:

   - a step of making prior patterns in a carbon printable layer (110) on top of the underlayer (120), wherein making of the prior patterns comprises a nanometric printing of the printable layer (110),
   - at least one step of modifying the underlayer (120) by ion implantation (421) within the underlayer (120), the implantation (421) being carried out throughout the printable layer (110), the implantation parameters (421) comprise in particular a direction of implantation (421) and wherein the direction of implantation (421) is perpendicular to a main plane in which the underlayer (120) extends, the implantation parameters (421) being selected so as to form in the underlayer (120) areas (122) modified by the implantation (421) and non-implanted areas, the non-implanted areas defining the subsequent patterns and having a geometry that depends on the prior patterns, the ions being selected from among the ions: hydrogen (H$_2$), helium (He), argon (Ar) or nitrogen (N$_2$);
   - after the modification step, at least one step of removing by etching the modified areas (122) by implantation, selectively with regards to the non-implanted areas, so as to leave the non-modified areas defining the subsequent patterns in place,

   **characterised in that:**

   the step of making the prior patterns in the carbon printable layer (110) leaves residual thicknesses (131) of printable layer (110) in place in the bottom of the patterns, the printable layer (110) then forming a continuous layer covering the underlayer (120), the implantation being carried out throughout the printable layer (110) comprising the prior patterns and said residual thicknesses (131), and **in that** the residual thickness (131) in the bottom of the patterns is larger than or equal to 20 nanometres ($10^{-9}$ metres) and preferably larger than or equal to 30 nm and is enough to form a barrier which traps carbon atoms pulled off the carbon printable layer (110) during said implantation (421) so as to prevent these atoms from penetrating inside the underlayer (120).

2. The method according to the preceding claim, wherein the materials of the printable layer (110) and of the underlayer (120) as well as the implantation (421) parameters, in particular the nature of the ions, are selected so that the materials of the printable layer (110) and of the underlayer (120) have identical ion penetration capabilities.

3. The method according to the preceding claim, wherein the implantation (421) parameters are selected so that the subsequent patterns have a geometry that is identical to that of the prior patterns.

4. The method according to any one of the preceding claims, wherein the etching step consists of a wet or dry etching.

5. The method according to any one of the preceding claims, wherein the step of making prior patterns is carried out so that for each of the prior patterns the residual thickness (131) of the printable layer (110) is larger than the minimum depth of implantation (421) of the ions, the minimum depth being considered according to the direction of implantation (421) and from the surface of the printable layer (110).

6. The method according to any one of claims 1 to 4, wherein the step of making prior patterns is carried out so that for each of the prior patterns the residual thickness (131) of the printable layer (110) is smaller than the minimum depth of implantation (421) of the ions, the minimum depth being considered according to the direction of implantation (421) and from the surface of the printable layer (110).

7. The method according to any one of the preceding claims, comprising, between the step of making the prior patterns and the implantation step (421), a step of depositing a protective layer covering the prior patterns.

8. The method according to the preceding claim, wherein the protective layer is a carbon layer deposited from a plasma.

9. The method according to any one of the preceding claims, wherein the underlayer (120) is a layer or a substrate whose material is selected from among: silicon, silicon germanium, germanium, quartz.

10. The method according to any one claims 1 to 8, wherein the underlayer (120) is a layer or a substrate whose material consists of SiOCH.

11. The method according to the preceding claim, wherein during the implantation (421), the SiOCH underlayer (120) is topped with a buffer layer (510) located between the printable layer (110) and the underlayer (120).

12. The method according to the preceding claim, wherein the buffer layer (510) is made of SixNy or SixOy, preferably SiN or $SiO_2$.

13. The method according to any one of the two preceding claims, wherein during the implantation (421), the buffer layer (510) has a thickness larger than or equal to 10 nm and preferably larger than or equal to 20 nm.

14. The method according to any one of claims 1 to 8, wherein the underlayer (120) forms the active layer of a photovoltaic cell or wherein the underlayer (120) is a sapphire substrate and forms with the subsequent patterns a patterned sapphire substrate (PSS).

15. A method for manufacturing a light-emitting diode (LED) comprising a patterned sapphire substrate (PSS), wherein the patterned sapphire substrate (PSS) is obtained by the method of the preceding claim.

# Art Antérieur

105

100

112

110

120

## Figure 1a

## Figure 1b

130

120

131

## Figure 1c

210

Z
Y
X

112

110

120

## Figure 2

# Art Antérieur

Figure 3a

Figure 3b

Figure 3c

Figure 3d

410 {

130

131

110

120

Z

Y  X

Figure 4a

420 {

421

110

122

120

Figure 4b

430 {

122

120

Figure 4c

440 {

120

Figure 4d

Figure 5

Figure 7

410 {

130

131

110

120

## Figure 6a

415 {

130

115

110

120

## Figure 6b

420 {

115

110

122

120

## Figure 6c

430 {

122

120

## Figure 6d

440 {

120

## Figure 6e

Z
Y⊗→X

Figure 8a

Figure 8b

Figure 8c

# Art antérieur

Pyr. Inv c-Si

## Figure 9a

## Figure 9b

Angle de la pyramide α en degrés

## Figure 9c

Imprint-Etching c-Si

## Figure 9d

Imprint-Etching mc-Si

## Figure 9e

Figure 10a

Figure 10b

Art antérieur

1410

110

131

120

110

122

120

122

120

1420

120

FIGURE 11a

FIGURE 11b

110

510

120

121

## Figure 12a

100

131    131    131

130

510

120

121

## Figure 12b

131    131    131

421

110

510

120

122    122

121

122

122

## Figure 12c

510

120

122    122

121

122

## Figure 12d

120

121

## Figure 12e

Figure 13

Figure 14

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20130284697 A

**Littérature non-brevet citée dans la description**

- Nucleation and epitaxial growth of Ge nanoislands on Si surface prepatterned by ion irradiation. *PHYSICA STATUS SOLIDI. A: APPLICATIONS AND MATERIALS SCIENCE,* 05 Juillet 2013, vol. 210 (8